# EUROPÄISCHE PATENTANMELDUNG

(11) **EP 4 760 272 A1**
(43) Veröffentlichungstag der Anmeldung: **17.06.2026**
(21) Anmeldenummer: 24219465.2
(22) Anmeldetag: 12.12.2024
(51) Int. Cl.: G01R 15/16, G01R 19/155, G01R 31/00

(54) **ERKENNEN DER VERFÜGBARKEIT EINER HOCHVOLTSPANNUNGSVERSORGUNG AN EINEM NUTZFAHRZEUG**

(71) Anmelder: Schmitz Cargobull AG, 48341 Altenberge (DE)
(72) Erfinder: Geiger, Fabian, 76461 Muggensturm (DE); Rübig, Michael, 77830 Bühlertal (DE); Bartelt, Gerd, 77767 Appenweier (DE)
(74) Vertreter: Cohausz & Florack

(57) **Zusammenfassung**

Es wird unter anderem offenbart ein Verfahren zum Erkennen der Anwesenheit einer Hochvoltspannungsversorgung an einem Nutzfahrzeug, wobei das Verfahren umfasst:
- Erhalten eines für das Anliegen einer ersten Versorgungswechselspannung an einem ersten Versorgungswechselspannungsleiter charakteristischen ersten Niedervoltwechselspannungssignals an einem ersten Niedervoltwechselspannungssignalleiter durch eine berührungslose Kopplung zwischen zumindest einem Teil des ersten Versorgungswechselspannungsleiters und zumindest einem Teil des ersten Niedervoltwechselspannungssignalleiters,
- Bestimmen, zumindest teilweise basierend auf dem ersten Niedervoltwechselspannungssignal, dass die Hochvoltspannungsversorgung an dem Nutzfahrzeug verfügbar ist.

## Beschreibung

### Gebiet

Beispielhafte Ausführungsformen der Erfindung betreffen das Erkennen der Verfügbarkeit einer Hochvoltspannungsversorgung an einem Nutzfahrzeug, insbesondere das Erkennen der Verfügbarkeit einer Hochvoltspannungsversorgung an einem Nutzfahrzeug durch eine berührungslose Kopplung.

### Hintergrund

Im Stand der Technik sind Nutzfahrzeuge wie Nutzfahrzeuganhänger bekannt, die mit einer Hochvoltspannungsversorgung wie einem elektrischen Versorgungsnetz, insbesondere einem Niederspannungsnetz, verbunden werden können, um elektrische Komponenten des Nutzfahrzeugs mit elektrischer Energie zu versorgen. Um die Verfügbarkeit der Hochvoltspannungsversorgung an dem Nutzfahrzeug erkennen zu können, wird im Stand der Technik beispielsweise auf Relais zurückgegriffen, die beispielsweise geschaltet werden, wenn eine Verbindung zu einer Hochvoltspannungsversorgung besteht.

### Zusammenfassung einiger beispielhafter Ausführungsformen der Erfindung

Diese aus dem Stand der Technik bekannte Lösung, um zu erkennen, ob eine Hochvoltspannungsversorgung an dem Nutzfahrzeug verfügbar ist, greifen auf elektrische Schaltungen wie ein Hochvoltrelais zurück, welche für Spannungen im Hochvoltbereich ausgelegt sind, was im Vergleich mit elektrischen Schaltungen im Niedervoltbereich mit einem erhöhten Aufwand und einer erhöhten Komplexität aufgrund der höheren Spannungen und der Sicherheitsanforderungen einhergeht. Eine Aufgabe der Erfindung ist es daher, diesen Nachteil zu überwinden und eine weniger aufwändige und einfachere Lösung zum Erkennen der Verfügbarkeit einer Hochvoltspannungsversorgung an einem Nutzfahrzeug bereitzustellen.

Eine weitere Aufgabe der Erfindung ist es, den Stand der Technik in vorteilhafterweise weiterzubilden.

Gemäß der Erfindung wird ein Verfahren zum Erkennen der Verfügbarkeit einer Hochvoltspannungsversorgung an einem Nutzfahrzeug offenbart, wobei das Verfahren umfasst:
- Erhalten eines für das Anliegen einer ersten Versorgungswechselspannung an einem ersten Versorgungswechselspannungsleiter charakteristischen ersten Niedervoltwechselspannungssignals an einem ersten Niedervoltwechselspannungssignalleiter durch eine berührungslose Kopplung zwischen zumindest einem Teil des ersten Versorgungswechselspannungsleiters und zumindest einem Teil des ersten Niedervoltwechselspannungssignalleiters,
- Bestimmen, zumindest teilweise basierend auf dem ersten Niedervoltwechselspannungssignal, dass die Hochvoltspannungsversorgung an dem Nutzfahrzeug verfügbar ist.

Das offenbarte Verfahren kann durch eine Vorrichtung ausgeführt werden. Dass das offenbarte Verfahren durch eine Vorrichtung ausgeführt werden kann, soll beispielsweise derart verstanden werden, dass die Vorrichtung das Verfahren allein ausführt, d.h. die Vorrichtung oder die Mittel der Vorrichtung alle Schritte des Verfahrens ausführen.

Dementsprechend wird gemäß der Erfindung ferner eine Vorrichtung offenbart, wobei die Vorrichtung Mittel eingerichtet zur Ausführung des offenbarten Verfahrens umfasst. Die Mittel können Hardware- und/oder Software-Komponenten umfassen. Die Mittel können beispielsweise Kopplungsmittel, Analog-Digital-Wandler und/oder Verarbeitungsmittel umfassen. Die Kopplungsmittel können beispielsweise Kondensatoren, elektrische Widerstände und elektrische Leiter umfassen. Die Verarbeitungsmittel können beispielsweise mindestens einen Speicher mit Anweisungen zur Anwendung von Algorithmen und mindestens einen Prozessor ausgebildet zur Anwendung von Algorithmen umfassen. Es versteht sich, dass der offenbarte Server auch andere, nicht aufgeführte Mittel umfassen kann.

Im Folgenden werden die Eigenschaften des offenbarten Verfahrens (im Folgenden auch als "Verfahren" bezeichnet) und der offenbarten Vorrichtung (im Folgenden auch als "Vorrichtung" bezeichnet) - teilweise beispielhaft - beschrieben. Es versteht sich, dass das Verfahren und die Vorrichtung zueinander korrespondieren, so dass die Offenbarung eines Merkmals für eine dieser Kategorien als Offenbarung eines korrespondierenden Merkmals für die anderen Kategorien verstanden werden soll.

Unter dem Erkennen der Verfügbarkeit einer Hochvoltspannungsversorgung an einem Nutzfahrzeug soll verstanden werden, dass bestimmt wird, ob eine Hochvoltspannungsversorgung verfügbar ist. Die Hochvoltspannungsversorgung soll beispielsweise als an dem Nutzfahrzeug verfügbar verstanden werden, wenn die Hochvoltspannungsversorgung mit dem Nutzfahrzeug verbunden ist, d.h. wenn eine erste von der Hochvoltspannungsversorgung bereitgestellte Wechselspannung als erste Versorgungswechselspannung an dem ersten Versorgungswechselspannungsleiter und/oder eine zweite von der Hochvoltspannungsversorgung bereitgestellte Wechselspannung als unten offenbarte zweite Versorgungswechselspannung an dem unten offenbarten zweiten Versorgungswechselspannungsleiter anliegt, z.B. weil ein erster Leiter (z.B. ein erster Außenleiter) der Hochvoltspannungsversorgung mit dem ersten Versorgungswechselspannungsleiter und/oder ein zweiter Leiter (z.B. ein zweiter Außenleiter) der Hochvoltspannungsversorgung mit dem ersten Versorgungswechselspannungsleiter verbunden ist/sind.

Beispielsweise handelt es sich bei der Hochvoltspannungsversorgung um ein elektrisches Versorgungsnetz wie ein Niederspannungsnetz. Dementsprechend kann die erste Versorgungswechselspannung und/oder die unten offenbarte zweite Versorgungswechselspannung eine Netzspannung des elektrischen Versorgungsnetzes wie einem Niederspannungsnetz sein. In Europa ist ein solches Niederspannungsnetz häufig ein Dreiphasennetz mit drei Außenleitern, einem Neutralleiter und einem Schutzleiter, das eine sinusförmige Wechselspannung mit (i) einer Frequenz von 50Hz und (ii) einem Effektivwert der Spannung zwischen einem Außenleiter und dem Neutralleiter von 230V und (iii) einem Effektivwert der Spannung zwischen zwei Außenleitern von 400V als Netzspannung bereitstellt. In Nordamerika stellt ein solches Niederspannungsnetz häufig eine sinusförmige Wechselspannung mit (i) einer Frequenz von 60HzHz und (ii) einem Effektivwert der Spannung zwischen zwei Außenleitern von beispielsweise 480V als Netzspannung bereit. Es versteht sich jedoch, dass die Erfindung nicht auf diese beispielhaften Niederspannungsnetze beschränkt ist. Zum Beispiel kann die Erfindung auch in anderen Regionen, in denen es Niederspannungsnetze mit anderen Netzspannungen und/oder Frequenzen gibt, angewendet werden. Auch ist die Erfindung nicht darauf beschränkt, dass die Hochvoltspannungsversorgung ein elektrisches Versorgungsnetz wie ein Niederspannungsnetz ist. Alternativ oder zusätzlich ist beispielsweise denkbar, dass, wenn das Nutzfahrzeug ein Nutzfahrzeuganhänger ist, die Hochvoltspannungsversorgung von einem Zugfahrzeug des Nutzfahrzeuganhängers bereitgestellt wird, z.B. stellt das Zugfahrzeug eine Hochvoltspannungsversorgung entsprechend einem elektrischen Versorgungsnetz wie einem europäischen oder nordamerikanischen Niederspannungsnetz bereit.

Das Nutzfahrzeug kann mit der Hochvoltspannungsversorgung beispielsweise durch eine Steckverbindung wie eine CEE-Steckverbindung oder eine Typ-2-Steckverbindung verbunden werden. Zum Beispiel ist die Steckverbindung eine fünfpolig ausgebildete Dreiphasensteckverbindung. Die fünf Pole können beispielsweise zur Verbindung mit drei Außenleitern, einem Neutralleiter und einem Schutzleiter dienen. CEE-Steckverbinder sind beispielsweise im internationalen Standard IEC 60309 spezifiziert und Typ-2-Steckverbinder sind beispielsweise im internationalen Standard IEC 62196 spezifiziert. Diese Standards werden von der Internationalen Elektrotechnischen Kommission (IEC) veröffentlicht und können derzeit im Internet unter https://iec.ch/ abgerufen werden. Es versteht sich, dass die Erfindung nicht auf CEE- und/oder Typ-2-Steckverbinder beschränkt ist.

In Nutzfahrzeugen wird häufig zwischen einem Niedervoltbereich und einem Hochvoltbereich unterschieden, wobei für elektrische Schaltungen (z.B. Bauteile und/oder Systeme) mit Wechselspannungen im Niedervoltbereich (je nach regionalen und/oder nationalen Bestimmungen) geringere Sicherheitsanforderungen als für Schaltungen (z.B. Bauteile und/oder Systeme) mit Spannungen im Hochvoltbereich bestehen können. Nach einer üblichen Definition gehören elektrische Schaltungen mit Wechselspannungen bis einschließlich 30V zum Niedervoltbereich und elektrische Schaltungen mit Wechselspannungen größer als 30V gehören zum Hochvoltbereich.

Zum Beispiel ist die erste Versorgungswechselspannung und/oder die unten offenbarte zweite Versorgungswechselspannung eine Wechselspannung im Hochvoltbereich, insbesondere kann die erste Versorgungswechselspannung und/oder die unten offenbarte zweite Versorgungswechselspannung eine sinusförmige Wechselspannung mit (i) einer Frequenz von 50 Hz und einem Effektivwert der Spannung zwischen einem Außenleiter und dem Neutralleiter von 230V und einem Effektivwert der Spannung zwischen zwei Außenleitern von 400V (z.B. im Fall, dass das Nutzfahrzeug mit einem europäischen Niederspannungsnetz als Hochvoltspannungsversorgung verbunden ist) oder (ii) einer Frequenz von 60 Hz und einem Effektivwert der Spannung zwischen zwei Außenleitern von 480V (z.B. im Fall, dass das Nutzfahrzeug mit einem nordamerikanischen Niederspannungsnetz als Hochvoltspannungsversorgung verbunden ist) sein.

Zum Beispiel ist das erste Niedervoltwechselspannungssignal und/oder das unten offenbarte zweite Niedervoltwechselspannungssignal eine Wechselspannung im Niedervoltbereich, insbesondere kann das erste Niedervoltwechselspannungssignal und/oder das unten offenbarte zweite Niedervoltwechselspannungssignal eine sinusförmige Wechselspannung mit einem Effektivwert der Spannung kleiner als 30V, vorzugsweise 15V, besonders vorzugsweise 10V sein. Die Frequenz des Niedervoltwechselspannungssignals kann beispielsweise 50Hz oder 60Hz betragen. Es versteht sich, dass das Niedervoltwechselspannungssignal neben der Wechselspannung auch einen Gleichspannungsanteil umfassen kann, z.B. um einen Arbeitspunkt einzustellen.

Unter einem Nutzfahrzeug soll insbesondere ein Nutzfahrzeuganhänger verstanden werden. Ein Nutzfahrzeuganhänger ist zum Beispiel ein Anhänger für einen Lastkraftwagen, wie ein Starrdeichselanhänger, ein Gelenkdeichselanhänger oder ein Sattelauflieger. Solche Nutzfahrzeuganhänger sind insbesondere für den Transport von Gütern, vorzugsweise Stückgütern, im öffentlichen Straßenverkehr vorgesehen. Zu diesem Zweck weisen Nutzfahrzeuganhänger unterschiedliche Arten von Nutzfahrzeugaufbauten auf, welche der Aufnahme der zu transportierenden Güter in einem Laderaum dienen. So sind beispielsweise Kofferaufbauten mit festen Seitenwänden, einer festen Stirnwand, einer durch Flügeltüren gebildeten Rückwand und einem festen Dach bekannt, welche den Laderaum umschließen. Da die Kofferaufbauten geschlossen sind, sind Kofferaufbauten in besonderem Maße für den Transport von feuchtigkeitsempfindlichen und/oder temperaturempfindlichen Gütern, also beispielsweise für den sogenannten Trockentransport und/oder den Kühltransport geeignet. Neben Kofferaufbauten sind zudem sogenannte Planenaufbauten bekannt, bei denen die Seitenwände und das Dach durch wenigstens eine Plane verschlossen sind. Die Stirnwand ist bei Planenaufbauten meist als feste Wand ausgebildet, während die Rückwand regelmäßig durch zwei Flügeltüren gebildet wird, um den Laderaum bedarfsweise von hinten zu beladen. Wenn eine Plane entlang der Seitenwand verschoben werden kann, spricht man auch von sogenannten Curtainsidern. Dementsprechend soll unter einem Nutzfahrzeugaufbau beispielsweise ein Kofferaufbau, ein Planenaufbau und/oder ein Curtainsider verstanden werden.

Unter dem Erhalten eines für das Anliegen einer Versorgungswechselspannung (z.B. der ersten Versorgungswechselspannung und/oder der unten offenbarten zweiten Versorgungswechselspannung) an einem Versorgungswechselspannungsleiter (z.B. dem ersten Versorgungswechselspannungsleiter und/oder dem unten offenbarten zweiten Versorgungswechselspannungsleiter) charakteristischen Niedervoltwechselspannungssignals (z.B. des ersten Niedervoltwechselspannungssignals oder des unten offenbarten zweiten Niedervoltwechselspannungssignals) an einem Niedervoltwechselspannungssignalleiter (z.B. dem ersten Niedervoltwechselspannungssignalleiter und/oder dem unten offenbarten zweiten Niedervoltwechselspannungssignalleiter) durch eine berührungslose Kopplung zwischen zumindest einem Teil des Versorgungswechselspannungsleiters und zumindest einem Teil des Niedervoltwechselspannungssignalleiters soll beispielsweise verstanden werden, dass das Niedervoltwechselspannungssignal an dem Niedervoltwechselspannungssignalleiter erhalten wird, wenn eine Versorgungswechselspannung an dem Versorgungswechselspannungsleiter anliegt (z.B. angelegt wird, z.B. weil der Versorgungswechselspannungsleiter mit einem Leiter (z.B. einem Außenleiter) einer Hochvoltspannungsversorgung verbunden wird), ohne dass sich der Versorgungswechselspannungsleiter und der Niedervoltwechselspannungsleiter berühren.

Unter einer berührungslosen Kopplung soll beispielsweise verstanden werden, dass elektrische Energie zwischen zwei Leitern (z.B. (i) dem ersten Niedervoltwechselspannungssignalleiter und dem ersten Versorgungswechselspannungsleiter und/oder (ii) dem unten offenbarten zweiten Niedervoltwechselspannungssignalleiter und dem unten offenbarten zweiten Versorgungswechselspannungsleiter) kontaktlos übertragen wird. Beispielsweise handelt es sich bei der berührungslosen Kopplung um eine kapazitive Kopplung oder um eine induktive Kopplung. Dabei soll unter einer kapazitiven Kopplung beispielsweise verstanden werden, dass elektrische Energie kontaktlos aufgrund einer Potentialdifferenz zwischen den beiden Leitern, welche ein elektrisches Feld zwischen den beiden Leitern zur Folge hat, übertragen wird; und unter einer induktiven Kopplung soll beispielsweise verstanden werden, dass elektrische Energie kontaktlos aufgrund von Induktion zwischen den beiden Leitern übertragen wird. Ein Vorteil einer solchen berührungslosen Kopplung ist, dass der Versorgungswechselspannungsleiter und der Niedervoltwechselspannungssignalleiter voneinander galvanisch getrennt sind, so dass der Niedervoltwechselspannungssignalleiter und damit verbundene Schaltungen kein Teil des Hochvoltbereichs werden, solange das Niedervoltwechselspannungssignal im Niedervoltbereich liegt.

Dass das Niedervoltwechselspannungssignal charakteristisch für die Versorgungswechselspannung ist, soll beispielsweise derart verstanden werden, dass das Niedervoltwechselspannungssignal auf der Versorgungswechselspannung basiert. Zum Beispiel können Eigenschaften des Niedervoltwechselspannungssignals wie Amplitude, Effektivwert, Frequenz und/oder Phasenwinkel einen Rückschluss auf Eigenschaften der Versorgungswechselspannung erlauben (z.B. von der Versorgungswechselspannung abhängen). Zum Beispiel können die vorgegebenen Eigenschaften absolut (z.B. als absoluter Wert) oder relativ (z.B. im Vergleich und/oder Abhängigkeit zu anderen Eigenschaften und/oder Werten) definiert sein. Zum Beispiel sind die Frequenz des Niedervoltwechselspannungssignals und die Frequenz der Versorgungswechselspannung zumindest im Wesentlichen gleich; und/oder der Phasenwinkel des Niedervoltwechselspannungssignals und der Phasenwinkel der Versorgungswechselspannung sind zumindest im Wesentlichen gleich; und/oder die Amplitude und/oder der Effektivwert der Spannung des Niedervoltwechselspannungssignals ist kleiner als die Amplitude und/oder der Effektivwert der Spannung der Versorgungswechselspannung.

Bei einem Versorgungswechselspannungsleiter (z.B. dem ersten Versorgungswechselspannungsleiter und/oder dem unten offenbarten Versorgungswechselspannungsleiter) kann es sich beispielsweise um einen elektrischen Leiter handeln, der eingerichtet ist, einen oder mehrere Verbraucher des Nutzfahrzeugs mit elektrischer Energie zu versorgen, wenn die Hochvoltspannungsversorgung an dem Nutzfahrzeug verfügbar ist. Zu diesem Zweck kann der Versorgungswechselspannungsleiter derart dimensioniert sein, dass er die von dem/den Verbraucher(n) benötigte Leistung übertragen kann. Bei einem Niedervoltwechselspannungssignalleiter (z.B. dem ersten Niedervoltwechselspannungssignalleiter und/oder dem unten offenbarten zweiten Niedervoltwechselspannungssignalleiter) kann es sich beispielsweise um einen elektrischen Leiter handeln, der nicht vorgesehen und dementsprechend auch nicht dafür eingerichtet ist, einen oder mehrere Verbraucher des Nutzfahrzeugs mit elektrischer Energie zu versorgen, wenn die Hochvoltspannungsversorgung an dem Nutzfahrzeug verfügbar ist. Dementsprechend muss der Niedervoltwechselspannungssignalleiter auch nicht derart dimensioniert sein, dass er die von dem/den Verbraucher(n) benötigte Leistung übertragen kann, so dass der Querschnitt und/oder der Durchmesser des Niedervoltwechselspannungssignalleiters (z.B. des ersten Niedervoltwechselspannungssignalleiters und/oder des unten offenbarten zweiten Niedervoltwechselspannungssignalleiters) kleiner als der Querschnitt und/oder der Durchmesser des Versorgungswechselspannungsleiters (z.B. des ersten Versorgungswechselspannungsleiters und/oder des unten offenbarten Versorgungswechselspannungsleiters) sein kann.

Unter dem Bestimmen, zumindest teilweise basierend auf dem ersten Niedervoltwechselspannungssignal, dass die Hochvoltspannungsversorgung an dem Nutzfahrzeug verfügbar ist, soll beispielsweise verstanden werden, dass bestimmt wird, dass eine Hochvoltspannungsversorgung an dem Nutzfahrzeug verfügbar ist, wenn das erste Niedervoltwechselspannungssignal erhalten wird und/oder wenn das erste Niedervoltwechselspannungssignal eine oder mehrere vorgegebene Eigenschaften aufweist und/oder wenn bestimmt wird, dass das erste Niedervoltwechselspannungssignal eine oder mehrere vorgegebene Eigenschaften aufweist. Das Bestimmen kann beispielsweise anhand vorgegebener Regeln (z.B. einem Algorithmus) erfolgen. Die Regeln können beispielsweise vorgeben, unter welchen Umständen bestimmt werden soll, dass eine Hochvoltspannungsversorgung an dem Nutzfahrzeug verfügbar ist. Zum Beispiel können die Regeln eine oder mehrere Eigenschaften des ersten Niedervoltwechselspannungssignals vorgeben, bei deren Vorliegen (z.B. wenn bestimmt wird, dass das erste Niedervoltwechselspannungssignal diese Eigenschaften aufweist), bestimmt wird, dass eine Hochvoltspannungsversorgung an dem Nutzfahrzeug verfügbar ist. Zu diesen Eigenschaften gehören beispielsweise der Phasenwinkel des Niedervoltwechselspannungssignals und/oder die Frequenz des Niedervoltwechselspannungssignals und/oder die maximale Spannung des Niedervoltwechselspannungssignals und/oder die Amplitude der Spannung des Niedervoltwechselspannungssignals und/oder der Effektivwert der Spannung des Niedervoltwechselspannungssignals. Die Eigenschaften können beispielsweise derart gewählt werden, dass, wenn das erste Niedervoltwechselspannungssignal diese Eigenschaften aufweist, (z.B. mit einer hohen Wahrscheinlichkeit) erwartet wird, dass eine Hochvoltspannungsversorgung an dem Nutzfahrzeug verfügbar ist.

Zum Beispiel wird bestimmt, dass eine Hochvoltspannungsversorgung verfügbar ist, (i) wenn das erste Niedervoltwechselspannungssignal eine vorgegebene Frequenz aufweist und/oder bestimmt wird, dass das erste Niedervoltwechselspannungssignal eine vorgegebene Frequenz aufweist, und/oder (ii) wenn die Amplitude und/oder der Effektivwert des ersten Niedervoltwechselspannungssignals einen vorgegebenen Spannungsschwellwert überschreitet und/oder wenn bestimmt wird, dass die Amplitude und/oder der Effektivwert des ersten Niedervoltwechselspannungssignals einen vorgegebenen Spannungsschwellwert überschreitet.

Als Ergebnis des Bestimmens wird beispielsweise eine Angabe (z.B. eine binäre Angabe wie "0" = "verfügbar" und "1" = "nicht verfügbar") erhalten, ob die Hochvoltspannungsversorgung verfügbar ist oder nicht. Es versteht sich jedoch, dass die Erfindung nicht darauf beschränkt ist.

Die Erfindung stellt somit eine Lösung bereit, bei der keine galvanische Verbindung zu einem Versorgungswechselspannungsleiter (d.h. zum Hochvoltbereich) oder eine zusätzliche elektrische Schaltung wie ein Hochvoltrelais im Hochvoltbereich benötigt wird, um zu erkennen, ob eine Hochvoltspannungsversorgung an einem Nutzfahrzeug verfügbar ist. Die erfindungsgemäße Lösung ist somit einfacher und weniger aufwändig als die aus dem Stand der Technik bekannten und oben beschriebenen Lösungen zum Erkennen der Verfügbarkeit einer Hochvoltspannungsversorgung an einem Nutzfahrzeug, bei denen auf elektrische Schaltungen im Hochvoltbereich zurückgegriffen wird.

Weitere Vorteile der offenbarten Erfindung werden nachfolgend anhand beispielhafter Ausführungsformen des offenbarten Verfahrens und der offenbarten Vorrichtung beschrieben.

In beispielhaften Ausführungsformen ist die berührungslose Kopplung zwischen zumindest dem Teil des ersten Versorgungswechselspannungsleiters und zumindest dem Teil des ersten Niedervoltwechselspannungssignalleiters eine kapazitive Kopplung. Dabei soll unter einer kapazitiven Kopplung, wie oben offenbart, beispielsweise verstanden werden, dass elektrische Energie kontaktlos aufgrund einer Potentialdifferenz zwischen den beiden Leitern, welche ein elektrisches Feld zwischen den beiden Leitern zur Folge hat, übertragen wird.

In beispielhaften Ausführungsformen umfasst das Verfahren ferner:
- Bestimmen der Amplitude der Spannung des ersten Niedervoltwechselspannungssignals.

Unter dem Bestimmen der Amplitude der Spannung des ersten Niedervoltwechselspannungssignals soll beispielsweise verstanden werden, dass die Amplitude der Spannung des Niedervoltwechselspannungssignals gemessen und/oder berechnet wird.

Die Amplitude der Spannung des ersten Niedervoltwechselspannungssignals kann beispielsweise bestimmt (z.B. berechnet) werden, indem die Differenz zwischen der maximalen Spannung des ersten Niedervoltwechselspannungssignals und dem arithmetischen Mittelwert der Spannung des ersten Niedervoltwechselspannungssignals bestimmt (z.B. berechnet) wird. Dabei kann die maximale Spannung des ersten Niedervoltwechselspannungssignals beispielsweise bestimmt (z.B. berechnet) werden, indem die maximale Spannung der (zeitveränderlichen) Spannung des ersten Niedervoltwechselspannungssignals in einer vorgegebenen Zeitdauer (z.B. zumindest einer Periodendauer im Falle einer sinusförmigen Wechselspannung) bestimmt (z.B. berechnet) wird; und der arithmetische Mittelwert der Spannung des ersten Niedervoltwechselspannungssignals kann beispielsweise bestimmt (z.B. berechnet) werden, indem der arithmetische Mittelwert der Spannung des ersten Niedervoltwechselspannungssignals für eine vorgegebene Zeitdauer (z.B. zumindest einer Periodendauer im Falle einer sinusförmigen Wechselspannung) bestimmt (z.B. berechnet) wird. Das Bestimmen basierend auf der Amplitude hat dementsprechend beispielsweise den Vorteil, dass das Bestimmen, dass eine Hochvoltspannungsversorgung an dem Nutzfahrzeug verfügbar, ist, gegenüber Störungen wie Rauschen des ersten Niedervoltwechselspannungssignals weniger empfindlich ist, weil die Amplitude die maximale Differenz zwischen der Spannung des ersten Niedervoltwechselspannungssignals und dem arithmetischen Mittelwert der Spannung des ersten Niedervoltwechselspannungssignals beschreibt.

Zum Beispiel wird bestimmt, dass die Hochvoltspannungsversorgung an dem Nutzfahrzeug verfügbar ist, wenn die zuvor bestimmte Amplitude der Spannung des ersten Niedervoltwechselspannungssignals einen vorgegebenen Spannungsschwellwert überschreitet. Wie oben offenbart, kann der Spannungsschwellwert derart gewählt sein, dass (mit einer hohen Wahrscheinlichkeit) erwartet wird, dass die Hochvoltspannungsversorgung an dem Nutzfahrzeug verfügbar ist, wenn die Amplitude der Spannung des ersten Niedervoltwechselspannungssignals den vorgegebenen Spannungsschwellwert überschreitet.

Es versteht sich, dass die Erfindung nicht hierauf beschränkt ist. Alternativ oder zusätzlich kann das Verfahren ferner beispielsweise umfassen:
- Bestimmen des Effektivwerts der Spannung des ersten Niedervoltwechselspannungssignals; und/oder
- Bestimmen der maximalen Spannung des ersten Niedervoltwechselspannungssignals.

Unter dem Bestimmen des Effektivwerts der Spannung des ersten Niedervoltwechselspannungssignals und/oder der maximalen Spannung des ersten Niedervoltwechselspannungssignals soll beispielsweise verstanden werden, dass der Effektivwert der Spannung des Niedervoltwechselspannungssignals und/oder die maximale Spannung des Niedervoltwechselspannungssignals gemessen und/oder berechnet wird.

Der Effektivwert der Spannung des ersten Niedervoltwechselspannungssignals kann beispielsweise bestimmt (z.B. berechnet) werden, indem der quadratische Mittelwert der (zeitveränderlichen) Spannung des ersten Niedervoltwechselspannungssignals über eine vorgegebene Zeitdauer (z.B. zumindest einer Periodendauer im Falle einer sinusförmigen Wechselspannung) bestimmt (z.B. berechnet) wird. Das Bestimmen basierend auf dem Effektivwert hat dementsprechend beispielsweise den Vorteil, dass das Bestimmen, dass eine Hochvoltspannungsversorgung an dem Nutzfahrzeug verfügbar ist, gegenüber kurzzeitig auftretenden Störungen des ersten Niedervoltwechselspannungssignals weniger empfindlich ist.

Die maximale Spannung des ersten Niedervoltwechselspannungssignals kann, wie oben offenbart, beispielsweise bestimmt (z.B. berechnet) werden, indem die maximale Spannung der (zeitveränderlichen) Spannung des ersten Niedervoltwechselspannungssignals in einer vorgegebenen Zeitdauer (z.B. zumindest einer Periodendauer im Falle einer sinusförmigen Wechselspannung) bestimmt (z.B. berechnet) wird. Die maximale Spannung kann somit besonders einfach bestimmt werden, zum Beispiel im Vergleich zur Amplitude oder zum Effektivwert.

Zum Beispiel wird bestimmt, dass die Hochvoltspannungsversorgung an dem Nutzfahrzeug verfügbar ist, wenn der zuvor bestimmte Effektivwert der Spannung des ersten Niedervoltwechselspannungssignals oder die zuvor bestimmte maximale Spannung des ersten Niedervoltwechselspannungssignals einen vorgegebenen Spannungsschwellwert überschreitet. Wie oben offenbart, kann der Spannungsschwellwert derart gewählt sein, dass (mit einer hohen Wahrscheinlichkeit) erwartet wird, dass die Hochvoltspannungsversorgung an dem Nutzfahrzeug verfügbar ist, wenn der Effektivwert der Spannung des ersten Niedervoltwechselspannungssignals den vorgegebenen Spannungsschwellwert überschreitet oder die maximale Spannung des ersten Niedervoltwechselspannungssignals den vorgegebenen Spannungsschwellwert überschreitet.

Es versteht sich, dass das Bestimmen, dass die Hochvoltspannungsversorgung an dem Nutzfahrzeug verfügbar ist, neben dem Vorliegen der Eigenschaft, dass die Amplitude der Spannung und/oder der Effektivwert der Spannung des ersten Niedervoltwechselspannungssignals und/oder die maximale Spannung des ersten Niedervoltwechselspannungssignals, auch noch das Vorliegen weiterer Eigenschaften (z.B. Phasenwinkel und/oder Frequenz der Spannung des ersten Niedervoltwechselspannungssignals und/oder des zweiten Niedervoltwechselspannungssignals und/oder Phasendifferenz zwischen einem ersten Phasenwinkel des ersten Niedervoltwechselspannungssignals und einem zweiten Phasenwinkel des zweiten Niedervoltwechselspannungssignals) voraussetzen kann.

In einer beispielhaften Ausführungsform umfasst das Verfahren ferner:
- Erhalten eines für das Anliegen einer zweiten Versorgungswechselspannung an einem zweiten Versorgungswechselspannungsleiter charakteristischen zweiten Niedervoltwechselspannungssignals an einem zweiten Niedervoltwechselspannungssignalleiter durch eine berührungslose Kopplung zwischen zumindest einem Teil des zweiten Versorgungswechselspannungsleiters und zumindest einem Teil des zweiten Niedervoltwechselspannungssignalleiters, wobei das Bestimmen, dass die Hochvoltspannungsversorgung an dem Nutzfahrzeug verfügbar ist, ferner zumindest teilweise auf dem zweiten Niedervoltwechselspannungssignal basiert.

Oben wurde bereits offenbart, was unter einem solchen Erhalten eines Niedervoltwechselspannungssignals (z.B. dem ersten Niedervoltwechselspannungssignal und/oder dem zweiten Niedervoltwechselspannungssignal) beispielsweise verstanden werden kann.

Dass das Bestimmen, dass die Hochvoltspannungsversorgung an dem Nutzfahrzeug verfügbar ist, ferner zumindest teilweise auf dem zweiten Niedervoltwechselspannungssignal basiert, soll beispielsweise derart verstanden werden, dass das Bestimmen, dass die Hochvoltspannungsversorgung an dem Nutzfahrzeug verfügbar ist, zumindest teilweise auf dem ersten Niedervoltwechselspannungssignal und zumindest teilweise auf dem zweiten Niedervoltwechselspannungssignal basiert.

Zum Beispiel kann vorgesehen sein, dass bestimmt wird, dass eine Hochvoltspannungsversorgung an dem Nutzfahrzeug verfügbar ist, wenn das erste Niedervoltwechselspannungssignal und das zweite Niedervoltwechselspannungssignal erhalten werden und/oder wenn das erste Niedervoltwechselspannungssignal und das zweite Niedervoltwechselspannungssignal eine oder mehrere vorgegebene Eigenschaften aufweisen und/oder wenn bestimmt wird, dass das erste Niedervoltwechselspannungssignal und das zweite Niedervoltwechselspannungssignal eine oder mehrere vorgegebene Eigenschaften aufweisen. Wie oben offenbart, kann das Bestimmen beispielsweise anhand vorgegebener Regeln (z.B. einem Algorithmus) erfolgen. Zum Beispiel können die Regeln eine oder mehrere Eigenschaften des ersten Niedervoltwechselspannungssignals und des zweiten Niedervoltwechselspannungssignals vorgeben, bei deren Vorliegen (z.B. wenn bestimmt wird, dass das erste Niedervoltwechselspannungssignal und das zweite Niedervoltwechselspannungssignal diese Eigenschaften aufweist), bestimmt wird, dass eine Hochvoltspannungsversorgung an dem Nutzfahrzeug verfügbar ist. Zu diesen Eigenschaften gehören beispielsweise die Phasendifferenz zwischen den Niedervoltwechselspannungssignalen (d.h. dem ersten Niedervoltwechselspannungssignal und dem zweiten Niedervoltwechselspannungssignal) und/oder die Frequenz der Niedervoltwechselspannungssignale und/oder die maximale Spannung der Niedervoltwechselspannungssignale und/oder die Amplitude der Spannungen der Niedervoltwechselspannungssignale und/oder die Effektivwerte der Spannungen der Niedervoltwechselspannungssignale. Die Eigenschaften können beispielsweise derart gewählt werden, dass, wenn das erste Niedervoltwechselspannungssignal und das zweite Niedervoltwechselspannungssignal diese Eigenschaften aufweisen, (z.B. mit einer hohen Wahrscheinlichkeit) erwartet wird, dass eine Hochvoltspannungsversorgung an dem Nutzfahrzeug verfügbar ist.

In beispielhaften Ausführungsformen umfasst das Verfahren ferner zumindest eines der folgenden Schritte:
- Bestimmen eines ersten Phasenwinkels des ersten Niedervoltwechselspannungssignals, und/oder
- Bestimmen eines zweiten Phasenwinkels des zweiten Niedervoltwechselspannungssignals, und/oder
- Bestimmen einer Phasendifferenz zwischen dem ersten Phasenwinkel des ersten Niedervoltwechselspannungssignals und dem zweiten Phasenwinkel des zweiten Niedervoltwechselspannungssignals, und/oder
- Bestimmen der Drehfeldrichtung zumindest teilweise basierend auf (i) dem ersten Phasenwinkel des ersten Niedervoltwechselspannungssignals und dem zweiten Phasenwinkel des zweiten Niedervoltwechselspannungssignals und/oder (ii) der Phasendifferenz zwischen dem ersten Phasenwinkel des ersten Niedervoltwechselspannungssignals und dem zweiten Phasenwinkel des zweiten Niedervoltwechselspannungssignals.

Dabei soll unter dem Bestimmen eines Phasenwinkels eines Niedervoltwechselspannungssignals (z.B. einem ersten Phasenwinkel des ersten Niedervoltwechselspannungssignals und/oder einem zweiten Phasenwinkel des zweiten Niedervoltwechselspannungssignals) beispielsweise verstanden werden, dass der Phasenwinkel der Wechselspannung des Niedervoltwechselspannungssignals bestimmt (z.B. berechnet und/oder gemessen) wird. Der Phasenwinkel beschreibt beispielsweise die zeitliche Verschiebung des Verlaufs einer sinusförmigen Wechselspannung gegenüber einer sinusförmigen Referenzwechselspannung. Beispielsweise bedeutet ein Phasenwinkel von 0°, dass keine zeitliche Verschiebung zwischen beiden Wechselspannungen vorhanden ist; und ein Phasenwinkel von 180° bedeutet beispielsweise, dass die Wechselspannung eine um eine halbe Periodendauer gegenüber der Referenzwechselspannung verschoben ist. Der Phasenwinkel kann beispielsweise anhand der zeitlichen Verschiebung der Nulldurchgänge der beiden Wechselspannungen bestimmt werden.

Zum Beispiel kann das erste Niedervoltwechselspannungssignal als Referenzwechselspannung verwendet werden, so dass der erste Phasenwinkel des ersten Niedervoltwechselspannungssignals 0° ist, und der zweite Phasenwinkel des zweiten Niedervoltwechselspannungssignals kann dann derart bestimmt werden, dass er die zeitliche Verschiebung des Verlaufs des zweiten Niedervoltwechselspannungssignals gegenüber dem ersten Niedervoltwechselspannungssignal beschreibt.

Unter dem Bestimmen einer Phasendifferenz zwischen dem ersten Phasenwinkel des ersten Niedervoltwechselspannungssignals und dem zweiten Phasenwinkel des zweiten Niedervoltwechselspannungssignals (d.h. der Phasendifferenz zwischen dem ersten Niedervoltwechselspannungssignal und dem zweiten Niedervoltwechselspannungssignal) soll beispielsweise verstanden werden, dass die Differenz zwischen dem ersten Phasenwinkel des ersten Niedervoltwechselspannungssignals und dem zweiten Phasenwinkel des zweiten Niedervoltwechselspannungssignals bestimmt (z.B. berechnet) wird.

Unter dem Bestimmen der Drehfeldrichtung zumindest teilweise basierend auf (i) dem ersten Phasenwinkel des ersten Niedervoltwechselspannungssignals und dem zweiten Phasenwinkel des zweiten Niedervoltwechselspannungssignals und/oder (ii) der Phasendifferenz zwischen dem ersten Phasenwinkel des ersten Niedervoltwechselspannungssignals und dem zweiten Phasenwinkel des zweiten Niedervoltwechselspannungssignals soll beispielsweise verstanden werden, dass der erste Phasenwinkel des ersten Niedervoltwechselspannungssignals und der zweite Phasenwinkel des zweiten Niedervoltwechselspannungssignals und/oder (ii) die Phasendifferenz zwischen dem ersten Phasenwinkel des ersten Niedervoltwechselspannungssignals und dem zweiten Phasenwinkel des zweiten Niedervoltwechselspannungssignals beim Bestimmen der Drehfeldrichtung berücksichtigt wird/werden. Zum Beispiel kann vorgegeben sein für welche Phasenwinkle und/oder für welche Phasendifferenz, welche Drehfeldrichtung bestimmt wird. Das Bestimmen kann beispielsweise anhand von vorgegebenen Regeln erfolgen. Die Regeln können beispielsweise vorgeben, dass die Drehfeldrichtung als rechtsdrehend bestimmt wird, wenn das zweite Niedervoltwechselspannungssignal dem ersten Niedervoltwechselspannungssignal mit einer Phasendifferenz von zumindest im Wesentlichen 120° folgt (z.B. wenn die Differenz zwischen dem ersten Phasenwinkel des ersten Niedervoltwechselspannungssignals und dem zweiten Phasenwinkel des zweiten Niedervoltwechselspannungssignals 100° bis 140°, vorzugsweise 120° beträgt) und dass die Drehfeldrichtung als linksdrehend bestimmt wird, wenn das zweite Niedervoltwechselspannungssignal dem ersten Niedervoltwechselspannungssignal mit einer Phasendifferenz von zumindest im Wesentlichen 240° folgt (z.B. wenn die Differenz zwischen dem ersten Phasenwinkel des ersten Niedervoltwechselspannungssignals und dem zweiten Phasenwinkel des zweiten Niedervoltwechselspannungssignals -100° bis -140°, vorzugsweise -120° beträgt).

In einer beispielhaften Ausführungsform wird bestimmt, dass die Hochvoltspannungsversorgung an dem Nutzfahrzeug verfügbar ist, wenn die Phasendifferenz zwischen dem ersten Phasenwinkel des ersten Niedervoltwechselspannungssignals und dem zweiten Phasenwinkel des zweiten Niedervoltwechselspannungssignals zumindest im Wesentlichen einem Betrag von 120°, z.B. einem Wert zwischen 100° und 140°, entspricht. Dass die Phasendifferenz zwischen dem ersten Phasenwinkel des ersten Niedervoltwechselspannungssignals und dem zweiten Phasenwinkel des zweiten Niedervoltwechselspannungssignals zumindest im Wesentlichen einem Betrag von 120°, z.B. einem Wert zwischen 100° und 140°, entspricht, soll insbesondere die beiden Fälle abdecken, dass die Phasendifferenz (i) 120° und (ii) -120° ist.

Vorteilhafterweise wird die Phasendifferenz durch das berührungslose Koppeln nicht verändert, so dass, wenn die Phasendifferenz zwischen dem ersten Phasenwinkel des ersten Niedervoltwechselspannungssignals und dem zweiten Phasenwinkel des zweiten Niedervoltwechselspannungssignals (zumindest im Wesentlichen) einem Betrag von 120° entspricht, auch die Phasendifferenz zwischen dem Phasenwinkel der ersten Versorgungswechselspannung und dem Phasenwinkel der zweiten Versorgungswechselspannung ebenfalls (zumindest im Wesentlichen) einem Betrag von 120° entspricht.

Dies ist besonders deshalb vorteilhaft, da die Phasenwinkel der Spannungen der Außenleiter eines von einer Hochvoltspannungsversorgung bereitgestellten Dreiphasenwechselstroms um den Betrag von 120° gegeneinander versetzt sind. Das Bestimmen basierend auf der Phasendifferenz hat dementsprechend beispielsweise den Vorteil, dass das Bestimmen, dass eine Hochvoltspannungsversorgung an dem Nutzfahrzeug verfügbar, ist, gegenüber dem unerwünschten berührungslosen Koppeln des ersten Niedervoltwechselspannungssignalleiters und des zweiten Niedervoltwechselspannungssignalleiters mit einem anderen Leiter (z.B. einem Leiter einer in der Nähe befindlichen Hochspannungsfreileitung) als dem ersten Versorgungswechselspannungsleiter und dem zweiten Versorgungswechselspannungsleiter unempfindlicher werden, weil bei einem solchen unerwünschten Koppeln keine Phasendifferenz, die (zumindest im Wesentlichen) einem Betrag von 120° entspricht, zwischen dem Phasenwinkel der ersten Versorgungswechselspannung und dem Phasenwinkel der zweiten Versorgungswechselspannung auftritt.

Es versteht sich, dass das Bestimmen, dass die Hochvoltspannungsversorgung an dem Nutzfahrzeug verfügbar ist, neben dem Vorliegen der Eigenschaft, dass die Phasendifferenz zwischen dem ersten Phasenwinkel des ersten Niedervoltwechselspannungssignals und dem zweiten Phasenwinkel des zweiten Niedervoltwechselspannungssignals zumindest im Wesentlichen einem Betrag von 120° entspricht, auch noch das Vorliegen weiterer Eigenschaften (z.B. maximale Spannung und/oder Effektivwert der Spannung und/oder Amplitude der Spannung und/oder Frequenz der Spannung des ersten Niedervoltwechselspannungssignals und/oder des zweiten Niedervoltwechselspannungssignals) voraussetzen kann.

In einer beispielhaften Ausführungsform umfasst das Bestimmen, dass die Hochvoltspannungsversorgung an dem Nutzfahrzeug verfügbar ist, ferner zumindest eines der folgenden Schritte:
- Bestimmen einer digitalen Repräsentation des ersten Niedervoltwechselspannungssignals und/oder einer digitalen Repräsentation des zweiten Niedervoltwechselspannungssignals, und/oder
- Anwenden einer DFT und/oder des Goertzel-Algorithmus auf die digitale Repräsentation des ersten Niedervoltwechselspannungssignals und/oder auf die digitale Repräsentation des zweiten Niedervoltwechselspannungssignals, und/oder
- Auswerten zumindest eines als Ergebnis des Anwendens der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltenen Spektralanteils, um die Frequenz und/oder die Amplitude und/oder den Phasenwinkel des ersten Niedervoltwechselspannungssignals und/oder des zweiten Niedervoltwechselspannungssignals zu bestimmen.

Unter einer digitalen Repräsentation eines Niedervoltwechselspannungssignals (z.B. des ersten Niedervoltwechselspannungssignals und/oder des zweiten Niedervoltwechselspannungssignals) soll beispielsweise ein Digitalsignal verstanden werden.

Unter dem Bestimmen einer digitalen Repräsentation eines Niedervoltwechselspannungssignals (z.B. des ersten Niedervoltwechselspannungssignals und/oder des zweiten Niedervoltwechselspannungssignals) soll beispielsweise verstanden werden, dass das Niedervoltwechselspannungssignal abgetastet und quantisiert wird, um eine digitale Repräsentation des Niedervoltwechselspannungssignals in Form eines zeitdiskreten und wertdiskreten Digitalsignals zu erhalten. Das Bestimmen der digitalen Repräsentation des Niedervoltwechselspannungssignals (z.B. des ersten Niedervoltwechselspannungssignals und/oder des zweiten Niedervoltwechselspannungssignals) kann beispielsweise durch einen Analog-Digital-Wandler erfolgen, der das Niedervoltwechselspannungssignal als Eingangssignal erhält und die digitale Repräsentation des Niedervoltwechselspannungssignals als Ausgangssignal ausgibt. Zum Beispiel kann die Vorrichtung einen solchen Analog-Digital-Wandler, der eingerichtet ist, das erste Niedervoltwechselspannungssignal und/oder das zweite Niedervoltwechselspannungssignal als jeweiliges Eingangssignal zu erhalten und eine digitale Repräsentation des ersten Niedervoltwechselspannungssignals und/oder eine digitale Repräsentation des zweiten Niedervoltwechselspannungssignals als jeweiliges Ausgangssignal auszugeben, umfassen.

Unter dem Anwenden einer diskreten Fourier-Transformation und/oder des Goertzel-Algorithmus auf die digitale Repräsentation des ersten Niedervoltwechselspannungssignals und/oder auf die digitale Repräsentation des zweiten Niedervoltwechselspannungssignals soll beispielsweise verstanden werden, dass die DFT und/oder der Goertzel-Algorithmus zumindest auf einen Abschnitt der digitalen Repräsentation des ersten Niedervoltwechselspannungssignals (z.B. einen Abschnitt der zumindest einer Periodendauer des ersten Niedervoltwechselspannungssignals entspricht) und/oder einen Abschnitt der digitalen Repräsentation des zweiten Niedervoltwechselspannungssignals (z.B. einen Abschnitt der zumindest einer Periodendauer des ersten Niedervoltwechselspannungssignals entspricht) angewendet wird.

Die DFT kann beispielsweise in Form der Fast-Fourier-Transformation (FFT) auf die digitale Repräsentation des ersten Niedervoltwechselspannungssignals und/oder die digitale Repräsentation des zweiten Niedervoltwechselspannungssignals angewendet werden. Bei der FFT handelt es sich um einen Algorithmus zur Anwendung der DFT. Als Ergebnis des Anwendens des FFT-Algorithmus auf die digitale Repräsentation des ersten Niedervoltwechselspannungssignals wird beispielsweise ein erstes Frequenzspektrum des ersten Niedervoltwechselspannungssignals (d.h. ein vollständiges Frequenzspektrum mit allen Spektralanteilen des ersten Niedervoltwechselspannungssignals) erhalten, und als Ergebnis des Anwendens des FFT-Algorithmus auf die digitale Repräsentation des zweiten Niedervoltwechselspannungssignals wird beispielsweise ein zweites Frequenzspektrum des zweiten Niedervoltwechselspannungssignals (d.h. ein vollständiges Frequenzspektrum mit allen Spektralanteilen des ersten Niedervoltwechselspannungssignals) erhalten. Basierend auf dem ersten Frequenzspektrum können beispielsweise die in dem ersten Niedervoltwechselspannungssignal hauptsächlich vorkommenden Frequenzen und/oder die Amplituden der zu diesen Frequenzen gehörigen Spannungen und/oder der Phasenwinkel der zu diesen Frequenzen gehörigen Spannungen bestimmt werden; und basierend auf dem zweiten Frequenzspektrum können beispielsweise die in dem zweiten Niedervoltwechselspannungssignal hauptsächlich vorkommenden Frequenzen und/oder die Amplituden der zu diesen Frequenzen gehörigen Spannungen und/oder der Phasenwinkel der zu diesen Frequenzen gehörigen Spannungen bestimmt werden. Dementsprechend kann unter dem zumindest eines als Ergebnis des Anwendens der DFT auf die digitale Repräsentation des ersten Niedervoltwechselspannungssignals und/oder auf die digitale Repräsentation des zweiten Niedervoltwechselspannungssignals erhaltenen Spektralanteils verstanden werden, dass basierend auf dem ersten Frequenzspektrum, die in dem ersten Niedervoltwechselspannungssignal hauptsächlich vorkommenden Frequenzen und/oder die Amplituden der zu diesen Frequenzen gehörigen Spannungen und/oder der Phasenwinkel der zu diesen Frequenzen gehörigen Spannungen bestimmt werden, und/oder dass basierend auf dem zweiten Frequenzspektrum, die in dem zweiten Niedervoltwechselspannungssignal hauptsächlich vorkommenden Frequenzen und/oder die Amplituden der zu diesen Frequenzen gehörigen Spannungen und/oder der Phasenwinkel der zu diesen Frequenzen gehörigen Spannungen bestimmt werden.

Diese Ausführungsform ist besonders vorteilhaft, weil sie eine digitale Signalverarbeitung betrifft, die es ermöglicht, zu bestimmen, dass eine Hochvoltspannungsversorgung an dem Nutzfahrzeug verfügbar ist. Eine solche digitale Signalverarbeitung kann durch elektrische Schaltungen im Niedervoltbereich realisiert werden und ist meist weniger aufwändig umzusetzen als die Realisierung entsprechender Schaltungen mit analoger Signalverarbeitung.

Der Goertzel-Algorithmus stellt eine besondere Form der DFT dar, bei der im Gegensatz zum FFT-Algorithmus kein vollständiges Frequenzspektrum (d.h. nicht alle Spektralanteile), sondern nur einzelne Spektralanteile berechnet werden. Zum Beispiel kann der Goertzel-Algorithmus derart auf die digitale Repräsentation des ersten Niedervoltwechselspannungssignals und/oder die digitale Repräsentation des zweiten Niedervoltwechselspannungssignals angewendet werden, dass als Ergebnis der/die jeweilige(n) Spektralanteil(e) (d.h. ein oder mehrere erste Spektralanteile des ersten Niedervoltwechselspannungssignals und/oder ein oder mehrere zweite Spektralanteile des zweiten Niedervoltwechselspannungssignals) für eine oder mehrere vorgegebenen Frequenzen erhalten wird/werden. Die vorgegebenen Frequenzen können beispielsweise derart gewählt werden, dass sie den für die erste und/oder zweite Versorgungswechselspannung erwarteten Frequenzen entsprechen. Zum Beispiel können die vorgegebenen Frequenzen 50 Hz (für den Fall eines europäischen Niederspannungsnetzes als Hochvoltspannungsversorgung) und/oder 60Hz (für den Fall eines nordamerikanischen Niederspannungsnetzes) umfassen. Dementsprechend kann unter dem Auswerten zumindest eines als Ergebnis des Anwendens des Goertzel-Algorithmus auf die digitale Repräsentation des ersten Niedervoltwechselspannungssignals und/oder auf die digitale Repräsentation des zweiten Niedervoltwechselspannungssignals erhaltenen Spektralanteils verstanden werden, dass basierend auf dem für zumindest eine solche vorgegebene Frequenz erhaltenen Spektralanteil des ersten Niedervoltwechselspannungssignals, die in dem ersten Niedervoltwechselspannungssignal enthaltene Amplitude der zu dieser Frequenz gehörigen Spannung und/oder der Phasenwinkel der zu dieser Frequenz gehörigen Spannung bestimmt werden, und/oder dass basierend auf dem für zumindest eine solche vorgegebene Frequenz erhaltenen Spektralanteil des zweiten Niedervoltwechselspannungssignals, die in dem zweiten Niedervoltwechselspannungssignal enthaltene Amplitude der zu dieser Frequenz gehörigen Spannung und/oder der Phasenwinkel der zu dieser Frequenz gehörigen Spannung bestimmt werden.

In einer beispielhaften Ausführungsform enthält ein als Ergebnis des Anwendens der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltener Spektralanteil zumindest eine der Frequenzen 50Hz oder 60Hz.

Dass ein als Ergebnis des Anwendens der DFT und/oder des Goertzel-Algorithmus auf die digitale Repräsentation des ersten Niedervoltwechselspannungssignals erhaltener Spektralanteil zumindest eine der Frequenzen 50Hz oder 60Hz enthält, soll beispielsweise derart verstanden werden, dass dieser Spektralanteil zumindest die Amplitude der Spannung mit 50Hz oder 60Hz des ersten Niedervoltwechselspannungssignals repräsentiert; und dass ein als Ergebnis des Anwendens der DFT und/oder des Goertzel-Algorithmus auf die digitale Repräsentation des zweiten Niedervoltwechselspannungssignals erhaltener Spektralanteil zumindest eine der Frequenzen 50Hz oder 60Hz enthält, soll beispielsweise derart verstanden werden, dass dieser Spektralanteil zumindest die Amplitude der Spannung mit 50Hz oder 60Hz des zweiten Niedervoltwechselspannungssignals repräsentiert.

Zum Beispiel kann vorgesehen sein, dass bestimmt wird, dass die Hochvoltspannungsversorgung an dem Nutzfahrzeug verfügbar ist, wenn der Spektralanteil, der als Ergebnis des Anwendens der DFT und/oder des Goertzel-Algorithmus auf die digitale Repräsentation des ersten Niedervoltwechselspannungssignals und/oder des zweiten Niedervoltwechselspannungssignals erhaltener Spektralanteil zumindest eine der Frequenzen 50Hz oder 60Hz enthält und wenn dieser Spektralanteil eine Amplitude der Spannung mit 50Hz oder 60Hz repräsentiert, die einen vorgegebenen Spannungsschwellwert (z.B. den oben offenbarten Spannungsschwellwert) überschreitet. Dies ist insbesondere deshalb vorteilhaft, weil die Netzspannung eines europäischen Niederspannungsnetz 50 Hz und die Netzspannung eines nordamerikanischen Niederspannungsnetzes 60 Hz beträgt, so dass das Vorliegen einer Spannung mit einer Amplitude oberhalb des vorgegebenen Spannungsschwellwerts mit einer Frequenz von 50 Hz auf die Verfügbarkeit eines europäischen Niederspannungsnetzes und das Vorliegen einer Spannung mit einer Amplitude oberhalb des vorgegebenen Spannungsschwellwerts mit einer Frequenz von 60 Hz auf die Verfügbarkeit eines nordamerikanischen Niederspannungsnetzes hindeutet. Alternativ zu einem durch einen absoluten Spannungswert definierten Spannungsschwellwert kann der vorgegebene Spannungsschwellwert zum Beispiel auch in relativer Form definiert sein, d.h. dass beispielsweise das der Spannungsschwellwert als überschritten bestimmt wird, wenn der als Ergebnis des Anwendens der DFT und/oder des Goertzel-Algorithmus erhaltene Spektralanteil jeweils eine Amplitude für die Spannungen mit 50 Hz und 60 Hz enthält und wenn eine der beiden Amplituden um einen vorgegebenen Faktor größer ist, als die andere der beiden Amplituden. Beispielsweise kann der Spannungsschwellwert derart definiert sein, dass er überschritten wird, wenn die Amplitude der Spannung mit 50 Hz zehn Mal größer als die Amplitude der Spannung mit 60 Hz ist oder umgekehrt.

In einer beispielhaften Ausführungsform ist beim Anwenden des Goertzel-Algorithmus auf die digitale Repräsentation des ersten Niedervoltwechselspannungssignals und/oder auf die digitale Repräsentation des zweiten Niedervoltwechselspannungssignals die Frequenzkomponente des Goertzel-Algorithmus auf 50 Hz und/oder 60 Hz eingestellt. Dies soll beispielsweise derart verstanden werden, dass der Goertzel-Algorithmus derart auf die die digitale Repräsentation des ersten Niedervoltwechselspannungssignals und/oder die digitale Repräsentation des zweiten Niedervoltwechselspannungssignals angewendet wird, dass als Ergebnis der jeweilige Spektralanteil für 50Hz und/oder der jeweilige Spektralanteil für 60Hz erhalten werden.

Das Anwenden des Goertzel-Algorithmus ist besonders vorteilhaft, weil für das Bestimmen, dass die Hochvoltspannungsversorgung an dem Nutzfahrzeug verfügbar ist, der Spektralanteil für 50 Hz und/oder der Spektralanteil für 60 Hz aus den oben offenbarten Gründen (insbesondere im Falle eines europäischen Niederspannungsnetzes mit einer Netzspannung mit einer Frequenz von 50 Hz und im Falle eines nordamerikanischen Niederspannungsnetzes mit einer Netzspannung mit einer Frequenz von 60 Hz) besonders interessant sein können, so dass die anderen Spektralanteile oder das vollständige Frequenzspektrum nicht zwingend bestimmt werden müssen. In solch einem Fall kann der Goertzel-Algorithmus deutlich weniger rechenintensiv als beispielsweise der FFT-Algorithmus sein, wodurch eine besonders unaufwändige und einfache Lösung zum Erkennen der Verfügbarkeit einer Hochvoltspannungsversorgung an einem Nutzfahrzeug bereitgestellt werden kann.

In einer beispielhaften Ausführungsform umfasst die Vorrichtung ferner ein erstes Kopplungsmittel, das eingerichtet ist, zur berührungslosen Kopplung zumindest eines Teils eines ersten Niedervoltwechselspannungssignalleiters mit zumindest einem Teil eines ersten Versorgungswechselspannungsleiters, und/oder ein zweites Kopplungsmittel, das eingerichtet ist, zur berührungslosen Kopplung zumindest eines Teils eines zweiten Niedervoltwechselspannungssignalleiters mit zumindest einem Teil eines zweiten Versorgungswechselspannungsleiters. Unter einem Kopplungsmittel (z.B. dem ersten Kopplungsmittel und/oder dem zweiten Kopplungsmittel) soll beispielsweise ein Mittel verstanden werden, welches zumindest einen Teil eines Niedervoltwechselspannungssignalleiters (z.B. des ersten Niedervoltwechselspannungssignalleiters und/oder des zweiten Niedervoltwechselspannungssignalleiters) berührungslos mit zumindest einem Teil eines Versorgungswechselspannungsleiters (z.B. des ersten Versorgungswechselspannungsleiters und/oder des zweiten Versorgungswechselspannungsleiters) koppelt.

Solch ein Kopplungsmittel kann beispielsweise derart eingerichtet sein, dass die Kopplung kapazitiv und/oder induktiv ist. Beispielsweise handelt es sich bei der berührungslosen Kopplung um eine kapazitive Kopplung und/oder um eine induktive Kopplung. Wie oben offenbart, soll dabei unter einer kapazitiven Kopplung beispielsweise verstanden werden, dass elektrische Energie kontaktlos aufgrund einer Potentialdifferenz zwischen den beiden Leitern, welche ein elektrisches Feld zwischen den beiden Leitern zur Folge hat, übertragen wird; und unter einer induktiven Kopplung soll beispielsweise verstanden werden, dass elektrische Energie kontaktlos aufgrund von Induktion zwischen den beiden Leitern übertragen wird.

Zum Beispiel ist ein solches Kopplungsmittel als ein erstes Flächenelement ausgebildet, wobei das erste Flächenelement von dem ersten Versorgungswechselspannungsleiter beabstandet angeordnet ist, und wobei das erste Flächenelement den zumindest einen Teil des ersten Versorgungswechselspannungsleiters zumindest teilweise umgibt. Zum Beispiel ist das erste Flächenelement elektrisch mit dem ersten Niedervoltwechselspannungssignalleiter verbunden und/oder ein Teil des ersten Niedervoltwechselspannungssignalleiters.

Zum Beispiel ist das zweite Kopplungsmittel als ein zweites Flächenelement ausgebildet, wobei das zweite Flächenelement von dem zweiten Versorgungswechselspannungsleiter beabstandet angeordnet ist, und wobei das zweite Flächenelement den zumindest einen Teil des zweiten Versorgungswechselspannungsleiters zumindest teilweise umgibt. Zum Beispiel ist das zweite Flächenelement elektrisch mit dem zweiten Niedervoltwechselspannungssignalleiter verbunden und/oder ein Teil des zweiten Niedervoltwechselspannungssignalleiters.

Dass ein solche Flächenelement von dem jeweiligen Versorgungswechselspannungsleiter beabstandet angeordnet ist, soll beispielsweise derart verstanden werden, dass das jeweilige Flächenelement den jeweiligen Versorgungswechselspannungsleiter nicht berührt, d.h. dass keine galvanische Verbindung zwischen dem jeweiligen Flächenelement und dem jeweiligen Versorgungswechselspannungsleiter besteht. Zum Beispiel beträgt der Abstand zwischen dem jeweiligen Flächenelement und dem jeweiligen Versorgungswechselspannungsleiter höchstens 5 mm oder 10 mm oder 15 mm.

### Detaillierte Beschreibung einiger beispielhafter Ausführungsformen

Es zeigen:
- Fig. 1: eine schematische Darstellung einer beispielhaften Ausführungsform einer Vorrichtung gemäß der Erfindung;
- Fig. 2(a): eine schematische Darstellung einer beispielhaften Ausführungsform eines Systems umfassend eine Vorrichtung gemäß der Erfindung;
- Fig 2(b): eine schematische Darstellung eines Ersatzschaltbilds einer berührungslosen Kopplung;
- Fig. 3: ein Flussdiagramm einer beispielhaften Ausführungsform eines Verfahrens gemäß der Erfindung.

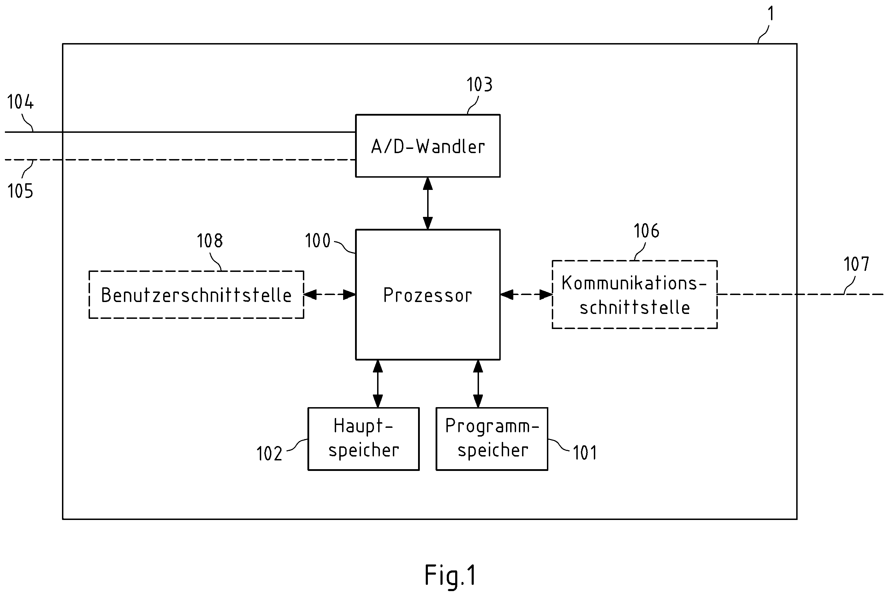

Fig. 1 zeigt eine schematische Darstellung einer beispielhaften Ausführungsform einer Vorrichtung 1 gemäß der Erfindung. Bei der Vorrichtung 1 handelt es sich um eine Vorrichtung für ein Nutzfahrzeug, zum Beispiel eine Steuervorrichtung für ein Nutzfahrzeug.

Die Vorrichtung 1 umfasst einen Prozessor 100 und verbunden mit dem Prozessor 100 einen ersten Speicher als Programmspeicher 101, einen zweiten Speicher als Hauptspeicher 102 und mindestens einen Analog- Digital-Wandler 103.

Unter einem Prozessor soll beispielsweise ein Mikroprozessor (Engl. Central Processing Unit, CPU), eine Mikrokontrolleinheit, ein Mikrocontroller, ein digitaler Signalprozessor (DSP), eine Anwendungsspezifische Integrierte Schaltung (ASIC), ein Field Programmable Gate Array (FPGA), oder ein graphischer Prozessor (Engl: Graphics Processing Unit, GPU) verstanden werden. Es versteht sich, dass die Vorrichtung 1 auch mehrere Prozessoren 100 umfassen kann.-

Prozessor 100 führt Anweisungen aus, die in Programmspeicher 101 gespeichert sind, und speichert beispielsweise Zwischenergebnisse oder Ähnliches in Hauptspeicher 102.

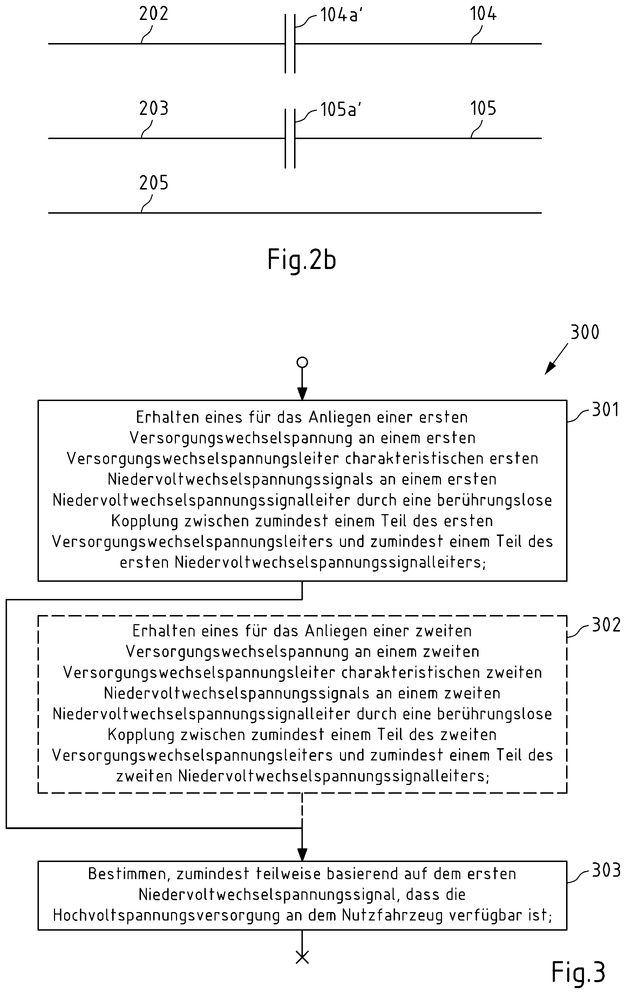

In Programmspeicher 101 sind beispielsweise Anweisungen gespeichert, die den Prozessor100, wenn er die Programmanweisungen ausführt, veranlassen, das Verfahren gemäß der Erfindung (z.B. das Verfahren gemäß dem in Fig. 3 dargestellten Flussdiagramm 300) zumindest teilweise auszuführen.

Programmspeicher 101 enthält ferner beispielsweise die Firmware oder das Betriebssystem der Vorrichtung 100, das beim Starten der Vorrichtung 100 zumindest teilweise in Hauptspeicher 102 geladen und vom Prozessor 100 ausgeführt wird. Insbesondere wird beim Starten der Vorrichtung 100 zumindest ein Teil des Kerns der Firmware oder des Betriebssystems in den Hauptspeicher 102 geladen und von Prozessor 100 ausgeführt.

Ein Beispiel für ein Betriebssystem ist ein Windows -, UNIX-, Linux-, Android-, Apple iOS- und/oder MAC OS-Betriebssystem. Das Betriebssystem oder die Firmware ermöglicht insbesondere die Verwendung der Vorrichtung 100 zur Datenverarbeitung. Es verwaltet beispielsweise Betriebsmittel wie einen Hauptspeicher und einen Programmspeicher, stellt unter anderem durch Programmierschnittstellen anderen Computerprogrammen grundlegende Funktionen zur Verfügung und steuert die Ausführung von Computerprogrammen.

Ein Programmspeicher ist beispielsweise ein nicht-flüchtiger Speicher wie ein Flash-Speicher, ein Magnetspeicher, ein EEPROM-Speicher (elektrisch löschbarer programmierbarer Nur-Lese-Speicher) und/oder ein optischer Speicher. Ein Hauptspeicher ist zum Beispiel ein flüchtiger oder nicht-flüchtiger Speicher, insbesondere ein Speicher mit wahlfreiem-Zugriff (RAM) wie ein statischer RAM-Speicher (SRAM), ein dynamischer RAM-Speicher (DRAM), ein ferroelektrischer RAM-Speicher (FeRAM) und/oder ein magnetischer RAM-Speicher (MRAM).

Hauptspeicher 102 und Programmspeicher 101 können auch als ein Speicher ausgebildet sein. Alternativ können Hauptspeicher 102 und/oder Programmspeicher 101 jeweils durch mehrere Speicher gebildet werden. Ferner können Hauptspeicher 102 und/oder Programmspeicher 101 auch Teil des Prozessors 100 sein.

Der Prozessor 100 steuert beispielsweise den Analog-Digital-Wandler 103. Der Analog-Digital-Wandler 103 ist beispielsweise eingerichtet ein erstes Niedervoltwechselspannungssignal über einen ersten Niedervoltwechselspannungssignalleiter 104 als Eingangssignal zu erhalten und eine digitale Repräsentation des ersten Niedervoltwechselspannung an den Prozessor 100 auszugeben. Ferner kann der Analog-Digital-Wandler 103 beispielsweise eingerichtet sein, ein optionales zweites Niedervoltwechselspannungssignal über einen optionalen Niedervoltwechselspannungssignalleiter 105 als Eingangssignal zu erhalten und eine digitale Repräsentation des zweiten Niedervoltwechselspannung an den Prozessor 100 auszugeben.

Zum Beispiel steuert der Prozessor 100 ferner die optionale Kommunikationsschnittstelle 106, welche beispielsweise eingerichtet ist, über einen Kommunikationspfad 107 mit anderen Vorrichtungen des Nutzfahrzeugs Informationen auszutauschen (z.B. zu senden und/oder zu empfangen). Die Kommunikationsschnittstelle 106 ist beispielsweise als Ethernet-, UART-, RS-232-, CAN-, K-Leitungs-, LIN- oder Flexray-Schnittstelle ausgebildet. Sie ist beispielsweise eingerichtet zur drahtgebundenen Kommunikation mit einem oder mehreren Vorrichtungen des Nutzfahrzeugs über den Kommunikationspfad 107, der über ein Ethernet-Netzwerk oder eine serielle Verbindung oder ein CAN-, K-Leitungs-, LIN- oder Flexray-Bussystem des Nutzfahrzeugs verläuft und/oder Teil davon ist. Ethernet ist zum Beispiel in den Standards der IEEE-802.3-Familie spezifiziert. RS-232 ist im Standard TIA-232-F, CAN ist in den Standards der ISO 11898-Familie, K-Leitung ist in den Standards ISO 9141 und ISO 14230-1, LIN ist in den Standards der ISO 17987-Familie und FlexRay in den Standards der ISO 17458-Familie spezifiziert. UART steht für Universal Asynchronous Receiver Transmitter und bezeichnet eine elektronische Schaltung, die eine serielle Schnittstelle realisiert. Es versteht sich, dass die Erfindung nicht darauf beschränkt ist. Alternativ ist zum Beispiel auch denkbar, dass die Kommunikationsschnittstelle als einfache digitale Schnittstelle ausgebildet ist, die ein oder mehrere Drahtleitungen mit High- und Low-Pegel ansteuert, um mit einer oder mehreren Vorrichtungen des Nutzfahrzeugs zu kommunizieren, wobei die ein oder mehreren Drahtleitungen in diesem Beispiel den Kommunikationspfad 107 bilden.

Außerdem kann Prozessor 100 beispielsweise Benutzerschnittstelle 108 steuern, die eingerichtet ist, Informationen an einen Benutzer auszugeben und/oder Informationen von einem Benutzer zu empfangen. Ein Beispiel für eine solche Benutzerschnittstelle ist ein berührungsempfindlicher Bildschirm und/oder eine Tastatur und/oder ein Bildschirm und/oder ein Lautsprecher und/oder ein Mikrofon.

Die Komponenten 100 bis 104, 106 und 108 der Vorrichtung 1 sind beispielsweise über einen oder mehrere Bussysteme (z.B. ein oder mehrere serielle und/oder parallele Busverbindungen) kommunikativ und/oder operativ miteinander verbunden.

Es versteht sich, dass die Vorrichtung 1 neben den Komponenten 100 bis 108 weitere Komponenten umfassen kann.

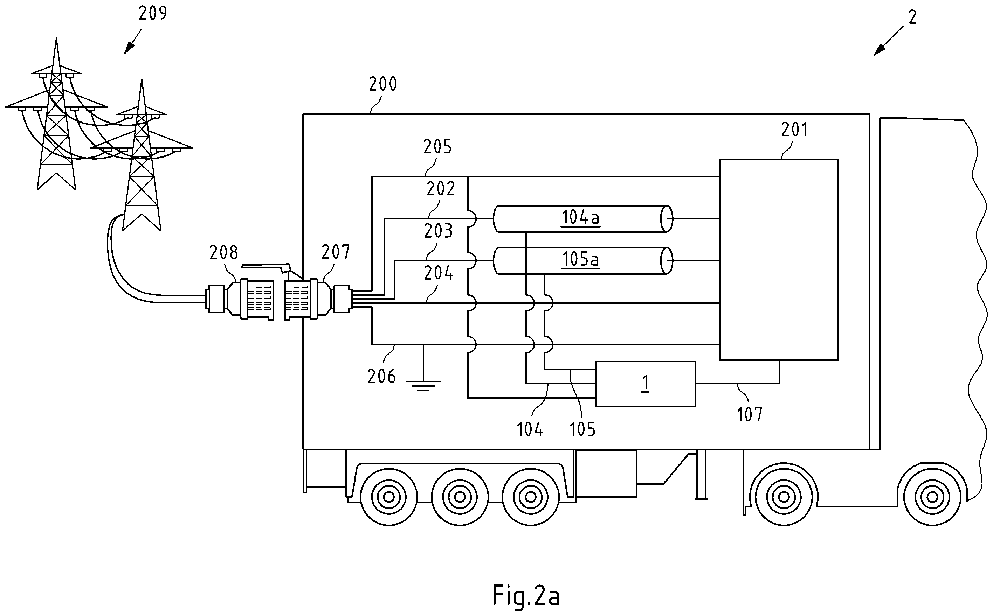

Fig. 2(a) zeigt eine schematische Darstellung einer beispielhaften Ausführungsform eines Systems umfassend einen Nutzfahrzeuganhänger 200 und eine Vorrichtung 1 gemäß der Erfindung. Im Folgenden wird beispielhaft davon ausgegangen, dass die in Fig. 1 dargestellte Vorrichtung 1 der in Fig. 2 dargestellten Vorrichtung 1 entspricht.

Neben der Vorrichtung 1 umfasst der Nutzfahrzeuganhänger 200 einen elektrischen Verbraucher 201 wie beispielsweise einen elektrischen Motor wie einen Drehstrommotor und/oder eine Transportkältemaschine mit einem Drehstrommotor. Der Verbraucher 201 ist in dem System 2 über die Leiter 202 bis 205 (d.h. einen ersten Versorgungswechselspannungsleiter 202, einen zweiten Versorgungswechselspannungsleiter 203, einen dritten Versorgungswechselspannungsleiter 204, einen Neutralleiter 205 und einen Schutzleiter 206) sowie die Steckverbindung 207, 208 mit einer Hochvoltspannungsversorgung 209 verbunden. Im Folgenden wird beispielhaft davon ausgegangen, dass es sich bei der Hochvoltspannungsversorgung 209 um ein europäisches Niederspannungsnetz in Form eines Dreiphasennetzes mit drei Außenleitern, einem Neutralleiter und einem Schutzleiter, das eine sinusförmige Wechselspannung mit (i) einer Frequenz von 50Hz und (ii) einem Effektivwert der Spannung zwischen einem Außenleiter und dem Neutralleiter von 230V und (iii) einem Effektivwert der Spannung zwischen zwei Außenleitern von 400V als Netzspannung bereitstellt, handelt.

Im Folgenden wird ferner beispielhaft davon ausgegangen, dass die Steckverbindung 207, 208 eine fünfpolige CEE-Steckverbindung umfassend eine CEE-Steckdose 207 und einen CEE-Stecker 208 ist. Die CEE-Steckdose 207 ist beispielsweise Teil des Nutzfahrzeugs 200. Die CEE-Steckdose ist eingerichtet, um mit einem CEE-Stecker verbunden zu werden, um eine CCE-Steckverbindung zu einer Hochvoltspannungsversorgung wie dem Dreiphasennetz 209 herzustellen. Für das System 2 bedeutet das, dass, wenn die CEE-Steckdose 207 mit dem CEE-Stecker 208 verbunden ist, dass jeder der Versorgungswechselspannungsleiter 202 bis 204 jeweils mit einem der drei Außenleiter des Dreiphasennetzes 209 und der Neutralleiter 205 mit dem Neutralleiter des Dreiphasennetzes 209 und der Schutzleiter 206 mit dem Schutzleiter des Dreiphasennetzes 209 verbunden ist. Wie oben offenbart, sind CEE-Steckverbinder im internationalen Standard IEC 60309 spezifiziert. Dieser Standard wird von der Internationalen Elektrotechnischen Kommission (IEC) veröffentlicht und kann derzeit im Internet unter https://iec.ch/ abgerufen werden.

Dementsprechend kann der Verbraucher 201, wenn die CEE-Steckverbindung 207, 208 hergestellt ist, durch das Dreiphasennetz 209 mit elektrischer Energie versorgt werden. Daneben kann der Verbraucher 201 aber auch durch eine elektrische Energiequelle des Nutzfahrzeuganhängers 200 wie eine Batterie und/oder einen Generator (beide nicht dargestellt) mit elektrischer Energie versorgt werden. Zum Beispiel ist der Verbraucher 201 eingerichtet von der Versorgung mit elektrischer Energie durch eine elektrische Energiequelle des Nutzfahrzeuganhängers 200 auf die Versorgung mit elektrischer Energie durch die Hochvoltspannungsversorgung 209 umzuschalten, wenn erkannt wird, dass die Hochvoltspannungsversorgung 209 an dem Nutzfahrzeuganhänger 200 verfügbar ist. Zu diesem Zweck kann Vorrichtung 1 beispielsweise mit dem Verbraucher 201 Informationen über den Kommunikationspfad 107 austauschen.

Ferner ist der erste Niedervoltwechselspannungssignalleiter 104 der Vorrichtung 1 in System 2 über das abgebildete Kopplungsmittel 104a mit dem ersten Versorgungswechselspannungsleiter 202 kapazitiv gekoppelt; und der zweite Niedervoltwechselspannungssignalleiter 105 der Vorrichtung 1 ist in System 2 über Kopplungsmittel 105a mit dem zweiten Versorgungswechselspannungsleiter 202 kapazitiv gekoppelt. Die Kopplungsmittel 104a und 105a sind jeweils hülsenförmig ausgebildet und derart angeordnet, dass ein Teil des jeweiligen Versorgungswechselspannungsleiters 202, 203 im Inneren des jeweiligen Kopplungsmittels 104a, 105a verläuft. Dabei ist das jeweilige Kopplungsmittel 104a, 105a beabstandet von dem jeweiligen Versorgungswechselspannungsleiter 202, 203 angeordnet und berührt diesen nicht, d.h. es besteht keine galvanische Verbindung zwischen dem Kopplungsmittel 104a, 105a und dem jeweiligen Versorgungswechselspannungsleiter 202, 203, so dass die Niedervoltwechselspannungssignalleiter 104 und 105 von den Versorgungswechselspannungsleitern 202 und 203 galvanisch getrennt sind und eine elektrische Energieübertragung zwischen dem jeweiligen Versorgungswechselspannungsleiter 202, 203 und dem jeweiligen Niedervoltwechselspannungssignalleiter 104, 105 nur aufgrund einer kapazitiven Kopplung zwischen dem jeweiligen Kopplungsmittel 104a, 105a und dem jeweiligen Versorgungswechselspannungsleiter 202, 203 stattfindet. Zum Beispiel kann eine Isolierung zwischen dem jeweiligen Kopplungsmittel 104a, 105a und dem jeweiligen Versorgungswechselspannungsleiter 202, 203 angeordnet sein. Um Störeinflüsse (z.B. unerwünschte kapazitive Kopplungen) durch andere Leitungen zu vermeiden, kann vorgesehen sein, dass die Kopplungsmittel 104a und 105a sowie die Niedervoltwechselspannungssignalleiter 104 und 105 ebenfalls isoliert sind und/oder derart angeordnet sind, dass sie einen Mindestabstand (z.B. mindestens 15mm oder 20mm) zu anderen Leitungen einhalten.

Eine schematische Darstellung eines Ersatzschaltbilds dieser kapazitiven Kopplungen ist in Fig. 2 (b) gezeigt. Die durch das jeweilige Kopplungsmittel 104a, 105a erreichte kapazitive Kopplung zwischen dem jeweiligen Versorgungswechselspannungsleiter 202, 203 und dem jeweiligen Niedervoltwechselspannungssignalleiter 104, 105 wird in dem Ersatzschaltbild durch den jeweiligen Kondensator 104a', 105a' repräsentiert. Wenn die hülsenförmigen Kopplungsmittel 104a und 105a jeweils ca. 10 cm lang sind, beträgt die Kapazität der Kondensatoren 104a` und 105a' jeweils ungefähr 2 pF bis 10 pF.

Wenn zwischen den jeweiligen Versorgungswechselspannungsleitern 202, 203 und dem Neutralleiter 205 jeweils eine sinusförmige Wechselspannung mit einem Effektivwert von 230V und einer Frequenz von 50 Hz abfällt, dann liegt aufgrund der kapazitiven Kopplung durch den jeweiligen Kondensator 104a', 105a' ein jeweiliges Niedervoltwechselspannungssignal in Form einer sinusförmigen Wechselspannung mit einem Effektivwert von ungefähr 100mV bis ungefähr 10V und einer Frequenz von 50 Hz an.

Fig. 3 zeigt ein Flussdiagramm 300 einer beispielhaften Ausführungsform eines Verfahrens gemäß der Erfindung. Im Folgenden wird beispielhaft davon ausgegangen, dass das Verfahren durch die in Fig. 1 dargestellte Vorrichtung 1 in dem in Fig. 2 dargestellten System 2 ausgeführt wird.

In einem Schritt 301 wird ein für das Anliegen einer ersten Versorgungswechselspannung an dem ersten Versorgungswechselspannungsleiter 202 charakteristischen ersten Niedervoltwechselspannungssignals an einem ersten Niedervoltwechselspannungssignalleiter 104 durch eine berührungslose Kopplung zwischen zumindest einem Teil (z.B. dem innerhalb des Kopplungsmittels 104a verlaufenden Teils) des ersten Versorgungswechselspannungsleiters 202 und zumindest einem Teil (z.B. dem Kopplungsmittel 104a) des ersten Niedervoltwechselspannungssignalleiters 104 erhalten.

In einem optionalen Schritt 302 wird ein für das Anliegen einer zweiten Versorgungswechselspannung an dem zweiten Versorgungswechselspannungsleiter 203 charakteristischen zweiten Niedervoltwechselspannungssignals an einem zweiten Niedervoltwechselspannungssignalleiter 105 durch eine berührungslose Kopplung zwischen zumindest einem Teil (z.B. dem innerhalb des Kopplungsmittels 105a verlaufenden Teils) des zweiten Versorgungswechselspannungsleiters 203 und zumindest einem Teil (z.B. dem Kopplungsmittel 105a) des zweiten Niedervoltwechselspannungssignalleiters 105 erhalten.

Bei der berührungslosen Kopplung handelt es sich im Falle des Systems 2, wie oben offenbart, um eine kapazitive Kopplung. Das durch eine solche kapazitive Kopplung an dem jeweiligen Niedervoltwechselspannungssignalleiter 104, 105 erhalten Niedervoltwechselspannungssignal soll beispielsweise als charakteristisch für die an dem jeweiligen Versorgungswechselspannungsleiter 202, 203 anliegende Versorgungswechselspannung verstanden werden, weil die Eigenschaften des jeweiligen Niedervoltwechselspannungssignal Rückschluss auf die Eigenschaften der jeweiligen Versorgungswechselspannung erlauben (z.B. gleichen sich die Frequenz des jeweiligen Niedervoltwechselspannungssignals und die Frequenz der jeweiligen Versorgungswechselspannungen) und/oder weil die Eigenschaften der Niedervoltwechselspannungssignale Rückschlüsse auf die Eigenschaften der Versorgungswechselspannungen erlauben (z.B. gleichen sich die Phasendifferenz zwischen den Niedervoltwechselspannungssignalen und die Phasendifferenz zwischen den Versorgungswechselspannungen).

In einem Schritt 303 wird bestimmt, zumindest teilweise basierend auf dem ersten Niedervoltwechselspannungssignal, dass die Hochvoltspannungsversorgung 209 an dem Nutzfahrzeug verfügbar ist. Ferner kann das Bestimmen in Schritt 303 zumindest teilweise auf dem zweiten Niedervoltwechselspannungssignal basieren.

Zum Beispiel wird bestimmt, dass die erste Versorgungswechselspannung an dem Nutzfahrzeug 200 verfügbar ist, wenn das erste Niedervoltwechselspannungssignal an dem ersten Niedervoltwechselspannungssignalleiter 104 und/oder das zweite Niedervoltwechselspannungssignal an dem zweiten Niedervoltwechselspannungssignalleiter 105 eine oder mehrere vorgegebene Eigenschaften aufweist und/oder wenn bestimmt wird, dass das erste Niedervoltwechselspannungssignal an dem ersten Niedervoltwechselspannungssignalleiter 104 und/oder das zweite Niedervoltwechselspannungssignal an dem zweiten Niedervoltwechselspannungssignalleiter 105 eine oder mehrere vorgegebene Eigenschaften aufweist. Das Bestimmen kann beispielsweise anhand vorgegebener Regeln (z.B. einem Algorithmus) erfolgen. Beispielsweise können die Regeln vorgeben, unter welchen Umständen bestimmt werden soll, dass eine Hochvoltspannungsversorgung 209 an dem Nutzfahrzeug 200 verfügbar ist. Zum Beispiel geben die Regeln eine oder mehrere Eigenschaften für das erste Niedervoltwechselspannungssignal und/oder das zweite Niedervoltwechselspannungssignal vor, bei deren Vorliegen (z.B. wenn bestimmt wird, dass das erste Niedervoltwechselspannungssignal und/oder das zweite Niedervoltwechselspannungssignal diese Eigenschaften aufweisen) bestimmt wird, dass eine Hochvoltspannungsversorgung 209 an dem Nutzfahrzeug 200 verfügbar ist. Zu diesen Eigenschaften gehören beispielsweise, wie oben offenbart, der Phasenwinkel des ersten Niedervoltwechselspannungssignals und/oder die Frequenz des ersten Niedervoltwechselspannungssignals und/oder die maximale Spannung des ersten Niedervoltwechselspannungssignals und/oder die Amplitude der Spannung des ersten Niedervoltwechselspannungssignals und/oder der Effektivwert der Spannung des ersten Niedervoltwechselspannungssignals und/oder der Phasenwinkel des zweiten Niedervoltwechselspannungssignals und/oder die Frequenz des zweiten Niedervoltwechselspannungssignals und/oder die maximale Spannung des zweiten Niedervoltwechselspannungssignals und/oder die Amplitude der Spannung des zweiten Niedervoltwechselspannungssignals und/oder der Effektivwert der Spannung des zweiten Niedervoltwechselspannungssignals .

Zum Beispiel kann das Bestimmen durch Prozessor 100 ausgeführt werden. Beispielsweise erhält Prozessor 100 eine digitale Repräsentation des ersten Niedervoltwechselspannungssignals und eine digitale Repräsentation des zweiten Niedervoltwechselspannungssignals von dem Analog-Digital-Wandler 103 und wendet beispielsweise den Goertzel-Algorithmus auf die beiden digitalen Repräsentationen an, um den Spektralanteil des ersten Niedervoltwechselspannungssignals und den Spektralanteil des zweiten Niedervoltwechselspannungssignals für die Frequenz von 50 Hz zu erhalten, um basierend auf diesem Spektralanteil eine oder mehrere vorgegebene Eigenschaften des ersten Niedervoltwechselspannungssignals und des zweiten Niedervoltwechselspannungssignals zu bestimmen. Basierend auf diesen Eigenschaften kann der Prozessor dann bestimmen, dass eine Hochvoltspannungsversorgung 209 verfügbar ist. Zu diesem Zweck kann der Programmspeicher 102 beispielsweise Regeln umfassen, anhand derer der Prozessor 100 das Bestimmen durchführen kann.

Zum Beispiel geben die Regeln vor, dass bestimmt wird, dass eine Hochvoltspannungsversorgung 209 verfügbar ist, (i) wenn basierend auf den Spektralanteilen bestimmt wird, dass die Amplitude des ersten Niedervoltwechselspannungssignals und/oder des zweiten Niedervoltwechselspannungssignals für 50 Hz einen vorgegebenen Spannungsschwellwert überschreitet; und/oder wenn basierend auf den Spektralanteilen bestimmt wird, dass die Phasendifferenz zwischen dem Phasenwinkel des ersten Niedervoltwechselspannungssignals und dem Phasenwinkel des zweiten Niedervoltwechselspannungssignals 120° beträgt.

Es versteht sich, dass das Verfahren 300 neben den Schritten 301 bis 303 weitere Schritte umfassen kann. Zum Beispiel kann die Vorrichtung 1 den Verbraucher 201 in einem weiteren Schritt informieren, dass die Hochvoltspannungsversorgung 209 verfügbar ist, wenn in Schritt 303 bestimmt wurde, dass die Hochvoltspannungsversorgung 209 verfügbar ist. Zum Beispiel kann die Vorrichtung 1 eine entsprechende Information über den Kommunikationspfad 107 an die Verbraucher 201 kommunizieren.

Die in dieser Spezifikation beschriebenen beispielhaften Ausführungsformen der vorliegenden Erfindung sollen auch in allen Kombinationen miteinander offenbart verstanden werden. Insbesondere soll auch die Beschreibung eines von einer Ausführungsform umfassten Merkmals - sofern nicht explizit gegenteilig erklärt - vorliegend nicht so verstanden werden, dass das Merkmal für die Funktion des Ausführungsbeispiels unerlässlich oder wesentlich ist. Die Abfolge der in dieser Spezifikation geschilderten Schritte in den einzelnen Flussdiagrammen ist nicht zwingend, alternative Abfolgen der Schritte sind denkbar - soweit nicht anders angegeben. Die Schritte können auf verschiedene Art und Weise implementiert werden, so ist eine Implementierung in Software (durch Programmanweisungen), Hardware oder eine Kombination von beidem zur Implementierung der Schritte denkbar.

In den Patentansprüchen verwendete Begriffe wie "umfassen", "aufweisen", "beinhalten", "enthalten" und dergleichen schließen weitere Elemente oder Schritte nicht aus. Unter die Formulierung "zumindest teilweise" fallen sowohl der Fall "teilweise" als auch der Fall "vollständig". Die Formulierung "und/oder" soll dahingehend verstanden werden, dass sowohl die Alternative als auch die Kombination offenbart sein soll, also "A und/oder B" bedeutet "(A) oder (B) oder (A und B)". Eine Mehrzahl von Einheiten, Personen oder dergleichen bedeutet im Zusammenhang dieser Spezifikation mehrere Einheiten, Personen oder dergleichen. Die Verwendung des unbestimmten Artikels schließt eine Mehrzahl nicht aus. Eine einzelne Komponente kann die Funktionen mehrerer in den Patentansprüchen genannten Einheiten bzw. Einrichtungen ausführen. In den Patentansprüchen angegebene Bezugszeichen sind nicht als Beschränkungen der eingesetzten Mittel und Schritte anzusehen.

## Patentansprüche

1. Verfahren zum Erkennen der Anwesenheit einer Hochvoltspannungsversorgung an einem Nutzfahrzeug, wobei das Verfahren umfasst:
- Erhalten eines für das Anliegen einer ersten Versorgungswechselspannung an einem ersten Versorgungswechselspannungsleiter charakteristischen ersten Niedervoltwechselspannungssignals an einem ersten Niedervoltwechselspannungssignalleiter durch eine berührungslose Kopplung zwischen zumindest einem Teil des ersten Versorgungswechselspannungsleiters und zumindest einem Teil des ersten Niedervoltwechselspannungssignalleiters,
- Bestimmen, zumindest teilweise basierend auf dem ersten Niedervoltwechselspannungssignal, dass die Hochvoltspannungsversorgung an dem Nutzfahrzeug verfügbar ist.

2. Verfahren nach Anspruch 1, wobei die berührungslose Kopplung zwischen zumindest dem Teil des ersten Versorgungswechselspannungsleiters und zumindest dem Teil des ersten Niedervoltwechselspannungssignalleiters eine kapazitive Kopplung ist.

3. Verfahren nach einem der Ansprüche 1 und 2, wobei das Verfahren ferner umfasst:
- Bestimmen der Amplitude der Spannung des ersten Niedervoltwechselspannungssignals.

4. Verfahren nach Anspruch 3, wobei bestimmt wird, dass die Hochvoltspannungsversorgung an dem Nutzfahrzeug verfügbar ist, wenn die Amplitude der Spannung des ersten Niedervoltwechselspannungssignals einen vorgegebenen Spannungsschwellwert überschreitet.

5. Verfahren nach einem der Ansprüche 1 bis 4, wobei das Verfahren ferner umfasst:
- Erhalten eines für das Anliegen einer zweiten Versorgungswechselspannung an einem zweiten Versorgungswechselspannungsleiter charakteristischen zweiten Niedervoltwechselspannungssignals an einem zweiten Niedervoltwechselspannungssignalleiter durch eine berührungslose Kopplung zwischen zumindest einem Teil des zweiten Versorgungswechselspannungsleiters und zumindest einem Teil des zweiten Niedervoltwechselspannungssignalleiters, wobei das Bestimmen, dass die Hochvoltspannungsversorgung an dem Nutzfahrzeug verfügbar ist, ferner zumindest teilweise auf dem zweiten Niedervoltwechselspannungssignal basiert.

6. Verfahren nach Anspruch 5, wobei das Verfahren ferner zumindest einen der folgenden Schritte umfasst:
- Bestimmen eines ersten Phasenwinkels des ersten Niedervoltwechselspannungssignals, und/oder
- Bestimmen eines zweiten Phasenwinkels des zweiten Niedervoltwechselspannungssignals, und/oder
- Bestimmen einer Phasendifferenz zwischen dem ersten Phasenwinkel des ersten Niedervoltwechselspannungssignals und dem zweiten Phasenwinkel des zweiten Niedervoltwechselspannungssignals, und/oder
- Bestimmen der Drehfeldrichtung zumindest teilweise basierend auf (i) dem ersten Phasenwinkel des ersten Niedervoltwechselspannungssignals und dem zweiten Phasenwinkel des zweiten Niedervoltwechselspannungssignals und/oder (ii) der Phasendifferenz zwischen dem ersten Phasenwinkel des ersten Niedervoltwechselspannungssignals und dem zweiten Phasenwinkel des zweiten Niedervoltwechselspannungssignals.

7. Verfahren nach Anspruch 6, wobei bestimmt wird, dass die Hochvoltspannungsversorgung an dem Nutzfahrzeug verfügbar ist, wenn die Phasendifferenz zwischen dem ersten Phasenwinkel des ersten Niedervoltwechselspannungssignals und dem zweiten Phasenwinkel des zweiten Niedervoltwechselspannungssignals zumindest im Wesentlichen einem Betrag von 120° entspricht.

8. Verfahren nach einem der Ansprüche 5 bis 7, wobei das Bestimmen, dass die Hochvoltspannungsversorgung an dem Nutzfahrzeug verfügbar ist, ferner zumindest einen der folgenden Schritte umfasst:
- Bestimmen einer digitalen Repräsentation des ersten Niedervoltwechselspannungssignals und/oder einer digitalen Repräsentation des zweiten Niedervoltwechselspannungssignals, und/oder
- Anwenden einer DFT und/oder des Goertzel-Algorithmus auf die digitale Repräsentation des ersten Niedervoltwechselspannungssignals und/oder auf die digitale Repräsentation des zweiten Niedervoltwechselspannungssignals, und/oder
- Auswerten zumindest eines als Ergebnis des Anwendens der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltenen Spektralanteils, um die Frequenz und/oder die Amplitude und/oder den Phasenwinkel der digitalen Repräsentation des ersten Niedervoltwechselspannungssignals und/oder der digitalen Repräsentation des zweiten Niedervoltwechselspannungssignals zu bestimmen.

9. Verfahren nach Anspruch 8, wobei ein als Ergebnis des Anwendens der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltener Spektralanteil zumindest eine der Frequenzen 50Hz oder 60Hz enthält.

10. Verfahren nach einem der Ansprüche 8 und 9, wobei beim Anwenden des Goertzel-Algorithmus auf die digitale Repräsentation des ersten Niedervoltwechselspannungssignals und/oder auf die digitale Repräsentation des zweiten Niedervoltwechselspannungssignals die Frequenzkomponente des Goertzel-Algorithmus auf 50 Hz und/oder 60 Hz eingestellt ist.

11. Vorrichtung, umfassend Mittel, die eingerichtet sind, das Verfahren nach einem der Ansprüche 1 bis 10 auszuführen.

12. Vorrichtung nach Anspruch 11, wobei die Vorrichtung ferner umfasst:
- erstes Kopplungsmittel, das eingerichtet ist, zur berührungslosen Kopplung zumindest eines Teils eines ersten Niedervoltwechselspannungssignalleiters mit zumindest einem Teil eines ersten Versorgungswechselspannungsleiters, und/oder
- zweites Kopplungsmittel, das eingerichtet ist, zur berührungslosen Kopplung zumindest eines Teils eines zweiten Niedervoltwechselspannungssignalleiters mit zumindest einem Teil eines zweiten Versorgungswechselspannungsleiters.

13. Vorrichtung nach Anspruch 12, wobei das erste Kopplungsmittel und/oder das zweite Kopplungsmittel eingerichtet ist/sind, zur kapazitiven Kopplung.

14. Vorrichtung nach einem der Ansprüche 12 und 13, wobei das erste Kopplungsmittel als ein erstes Flächenelement ausgebildet ist, wobei das erste Flächenelement von dem ersten Versorgungswechselspannungsleiter beabstandet angeordnet ist, und wobei das erste Flächenelement zumindest den Teil des ersten Versorgungswechselspannungsleiters zumindest teilweise umgibt, und/oder wobei das zweite Kopplungsmittel als ein zweite Flächenelement ausgebildet ist, wobei das zweite Flächenelement von dem zweiten Versorgungswechselspannungsleiter beabstandet angeordnet ist, und wobei das zweite Flächenelement zumindest den Teil des zweiten Versorgungswechselspannungsleiters zumindest teilweise umgibt.

15. Vorrichtung nach einem der Ansprüche 12 bis 14, wobei das erste Kopplungsmittel und/oder das zweite Kopplungsmittel jeweils zumindest im Wesentlichen hülsenförmig ausgebildet sind.

## Geänderte Patentansprüche

### Geänderte Patentansprüche gemäss Regel 137(2) EPÜ.

1. Verfahren zum Erkennen der Anwesenheit einer Hochvoltspannungsversorgung an einem Nutzfahrzeug, wobei das Verfahren umfasst:
- Erhalten eines für das Anliegen einer ersten Versorgungswechselspannung an einem ersten Versorgungswechselspannungsleiter charakteristischen ersten Niedervoltwechselspannungssignals an einem ersten Niedervoltwechselspannungssignalleiter durch eine berührungslose Kopplung zwischen zumindest einem Teil des ersten Versorgungswechselspannungsleiters und zumindest einem Teil des ersten Niedervoltwechselspannungssignalleiters,
- Erhalten eines für das Anliegen einer zweiten Versorgungswechselspannung an einem zweiten Versorgungswechselspannungsleiter charakteristischen zweiten Niedervoltwechselspannungssignals an einem zweiten Niedervoltwechselspannungssignalleiter durch eine berührungslose Kopplung zwischen zumindest einem Teil des zweiten Versorgungswechselspannungsleiters und zumindest einem Teil des zweiten Niedervoltwechselspannungssignalleiters,
- Bestimmen einer digitalen Repräsentation des ersten Niedervoltwechselspannungssignals und/oder einer digitalen Repräsentation des zweiten Niedervoltwechselspannungssignals, und/oder
- Anwenden eines Algorithmus, insbesondere einer DFT und/oder des Goertzel-Algorithmus, auf die digitale Repräsentation des ersten Niedervoltwechselspannungssignals und/oder auf die digitale Repräsentation des zweiten Niedervoltwechselspannungssignals, und/oder
- Auswerten zumindest eines als Ergebnis des Anwendens des Algorithmus, insbesondere der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltenen Spektralanteils, um die Frequenz und/oder die Amplitude und/oder den Phasenwinkel der digitalen Repräsentation des ersten Niedervoltwechselspannungssignals und/oder der digitalen Repräsentation des zweiten Niedervoltwechselspannungssignals zu bestimmen, wobei ein als Ergebnis des Anwendens des Algorithmus, insbesondere der DFT und/oder des Goertzel-Algorithmus auf die digitale Repräsentation des ersten Niedervoltwechselspannungssignals und/oder auf die digitale Repräsentation des zweiten Niedervoltwechselspannungssignals erhaltener Spektralanteil zumindest eine der Frequenzen 50Hz oder 60Hz enthält,
- Bestimmen, zumindest teilweise basierend auf dem ersten Niedervoltwechselspannungssignal und zumindest teilweise auf dem zweiten Niedervoltwechselspannungssignal, dass die Hochvoltspannungsversorgung an dem Nutzfahrzeug verfügbar ist.

2. Verfahren nach Anspruch 1, wobei die berührungslose Kopplung zwischen zumindest dem Teil des ersten Versorgungswechselspannungsleiters und zumindest dem Teil des ersten Niedervoltwechselspannungssignalleiters eine kapazitive Kopplung ist.

3. Verfahren nach einem der Ansprüche 1 und 2, wobei das Verfahren ferner umfasst:
- Bestimmen der Amplitude der Spannung des ersten Niedervoltwechselspannungssignals.

4. Verfahren nach Anspruch 3, wobei bestimmt wird, dass die Hochvoltspannungsversorgung an dem Nutzfahrzeug verfügbar ist, wenn die Amplitude der Spannung des ersten Niedervoltwechselspannungssignals einen vorgegebenen Spannungsschwellwert überschreitet.

5. Verfahren nacheinem der Ansprüche 1 bis 4, wobei das Verfahren ferner zumindest einen der folgenden Schritte umfasst:
- Bestimmen eines ersten Phasenwinkels des ersten Niedervoltwechselspannungssignals, und/oder
- Bestimmen eines zweiten Phasenwinkels des zweiten Niedervoltwechselspannungssignals, und/oder
- Bestimmen einer Phasendifferenz zwischen dem ersten Phasenwinkel des ersten Niedervoltwechselspannungssignals und dem zweiten Phasenwinkel des zweiten Niedervoltwechselspannungssignals, und/oder
- Bestimmen der Drehfeldrichtung zumindest teilweise basierend auf (i) dem ersten Phasenwinkel des ersten Niedervoltwechselspannungssignals und dem zweiten Phasenwinkel des zweiten Niedervoltwechselspannungssignals und/oder (ii) der Phasendifferenz zwischen dem ersten Phasenwinkel des ersten Niedervoltwechselspannungssignals und dem zweiten Phasenwinkel des zweiten Niedervoltwechselspannungssignals.

6. Verfahren nach Anspruch 5, wobei bestimmt wird, dass die Hochvoltspannungsversorgung an dem Nutzfahrzeug verfügbar ist, wenn die Phasendifferenz zwischen dem ersten Phasenwinkel des ersten Niedervoltwechselspannungssignals und dem zweiten Phasenwinkel des zweiten Niedervoltwechselspannungssignals zumindest im Wesentlichen einem Betrag von 120° entspricht.

7. Verfahren nach einem der Ansprüche 1 bis 6, wobei beim Anwenden des Goertzel-Algorithmus auf die digitale Repräsentation des ersten Niedervoltwechselspannungssignals und/oder auf die digitale Repräsentation des zweiten Niedervoltwechselspannungssignals die Frequenzkomponente des Goertzel-Algorithmus auf 50 Hz und/oder 60 Hz eingestellt ist.

8. Vorrichtung, umfassend Mittel, die eingerichtet sind, das Verfahren nach einem der Ansprüche 1 bis 7 auszuführen, wobei die Vorrichtung ferner umfasst:
- erstes Kopplungsmittel, das eingerichtet ist, zur berührungslosen Kopplung zumindest eines Teils eines ersten Niedervoltwechselspannungssignalleiters mit zumindest einem Teil eines ersten Versorgungswechselspannungsleiters, und/oder
- zweites Kopplungsmittel, das eingerichtet ist, zur berührungslosen Kopplung zumindest eines Teils eines zweiten Niedervoltwechselspannungssignalleiters mit zumindest einem Teil eines zweiten Versorgungswechselspannungsleiters.

9. Vorrichtung nach Anspruch 8, wobei das erste Kopplungsmittel und/oder das zweite Kopplungsmittel eingerichtet ist/sind, zur kapazitiven Kopplung.

10. Vorrichtung nach einem der Ansprüche 8 und 9, wobei das erste Kopplungsmittel als ein erstes Flächenelement ausgebildet ist, wobei das erste Flächenelement von dem ersten Versorgungswechselspannungsleiter beabstandet angeordnet ist, und wobei das erste Flächenelement zumindest den Teil des ersten Versorgungswechselspannungsleiters zumindest teilweise umgibt, und/oder wobei das zweite Kopplungsmittel als ein zweite Flächenelement ausgebildet ist, wobei das zweite Flächenelement von dem zweiten Versorgungswechselspannungsleiter beabstandet angeordnet ist, und wobei das zweite Flächenelement zumindest den Teil des zweiten Versorgungswechselspannungsleiters zumindest teilweise umgibt.

11. Vorrichtung nach einem der Ansprüche 8 bis 10, wobei das erste Kopplungsmittel und/oder das zweite Kopplungsmittel jeweils zumindest im Wesentlichen hülsenförmig ausgebildet sind.
